# EUROPEAN PATENT APPLICATION

(11) **EP 4 704 497 A1**
(43) Date of publication of application: **04.03.2026**
(21) Application number: 24197353.6
(22) Date of filing: 29.08.2024
(51) Int. Cl.: H05K 1/09, H05K 1/11, H05K 3/46, H05K 3/00, H05K 1/02

(54) **COMPONENT CARRIER, METHOD FOR MANUFACTURING A COMPONENT CARRIER AND COMPONENT CARRIER ASSEMBLY**

(71) Applicant: AT & S Austria Technologie & Systemtechnik Aktiengesellschaft, 8700 Leoben-Hinterberg (AT)
(72) Inventor: SIERAKOWSKI, Jim, Osseo, MN 55369 (US); MOCK, Marian, 8700 Leoben (AT); BLASL, Juergen, 8793 Trofaiach (AT); SCHMID, Gerhard, 8793 Trofaiach (AT); LACKNER, Sebastian, 8773 Kammern i. L. (AT)
(74) Representative: Donatello, Daniele

(57) **Abstract**

The present invention relates to a component carrier (100), a method for manufacturing thereof, and to a component carrier assembly, wherein the component carrier (100) comprises a stack with a plurality of electrically conductive layer structures (10, 20) and at least one electrically insulating layer structure (30), wherein the insulating layer structure (30) is stacked in between two electrically conductive layer structures (10, 20), wherein the two electrically conductive layer structures (10, 20) are electrically connected one to each other by an electrically conductive element (40) comprising an electrically conductive paste (42) provided in a cavity (41) being located in between said two electrically conductive layer structures (10, 20), wherein said cavity (41) is in lateral direction delimited by a lateral wall of the electrically insulating layer structure (30), said lateral wall having two opposed portions with different inclinations relative to a contacting plane between the electrically insulating layer structure (30) and one of said two electrically conductive layer structures (10, 20) and with respect to a thickness direction of the stack.

## Description

### FIELD OF THE INVENTION

The present invention generally relates to a component carrier, comprising a stack, said stack comprising a plurality of electrically conductive layer structures and at least one electrically insulating layer structure, wherein at least one electrically insulating layer structure is stacked in between at least two electrically conductive layer structures, wherein at least two electrically conductive layer structures are electrically connected one to each other by at least one electrically conductive element, and wherein said electrically conductive element comprises an electrically conductive paste provided in a cavity being located at least partially within the at least one electrically insulating layer structure and in thickness direction in between said two electrically conductive layer structures electrically connecting one to each other.

Further, the present invention relates to a method for manufacturing a component carrier as described above.

Additionally, the present invention relates to a component carrier assembly comprising such a component carrier.

### TECHNICAL BACKGROUND

Component carriers as described above, methods for manufacturing them and component carrier assemblies comprising at least one component carrier as described above are generally known.

The quality of the electrical connection(s) between the electrically conductive layer structures is more and more important for ensuring the electrical, thermal, and mechanical performance of the component carrier. The connection quality is in particular crucial for sufficient electrical performance, reliability, and longevity of the component carrier.

High quality electrical interconnects can reduce the occurrence and magnitude of signal loss and distortion. Good quality electrical interconnects may also enable the creation of low resistance paths, which are essential for the efficient flow of electrical current, reducing power dissipation and heat generation. High quality electrical connections can also help to keep the risk of malfunction or failure low over the lifetime of a component carrier. Reliable electrical interconnects between different electrically conductive layer structures are more resistant to thermal cycling and mechanical stress over time, helping to prevent failures. They may also contribute to the mechanical strength. Proper electrical interconnects can also contribute significantly to heat dissipation.

With increasing miniaturization and package density, precision, reliability, and quality of the electrical connections become more critical for providing a component carrier with proper functionality over lifetime.

For the wide range of possible defects and defect patterns, various measures are known from prior art to reduce the risk of their occurrence in a life of a component carrier.

Against this background, the technical problem underlying the present invention is to provide an alternative, in particular an improved, component carrier, an alternative, in particular improved, method for manufacturing such a component carrier, and an alternative, in particular improved, component carrier assembly by which in particular the above described challenge is faced, and preferably the risk of contacting errors or electrical connection errors due to incomplete, insufficient, or faulty contacting or electrical connection can be reduced, more preferably with as little additional effort as possible and/or without significant disadvantages.

### SUMMARY OF THE INVENTION

With respect to the above, a component carrier, a method for manufacturing a component carrier, and a component carrier assembly comprising a component carrier are provided according to the respective independent patent claims. Advantageous embodiments of the present invention are defined by the dependent patent claims, the description, and the figures. The wording of the claims is hereby made part of the description by express reference.

According to a first aspect of the present invention, a component carrier is provided, wherein the component carrier comprises a stack, said stack comprising a plurality of electrically conductive layer structures, in particular at least two electrically conductive layer structures, and at least one electrically insulating layer structure, wherein the at least one electrically insulating layer structure is stacked in between at least two electrically conductive layer structures, in particular in stacking direction. The at least two electrically conductive layer structures are electrically connected one to each other by at least one electrically conductive element, wherein said electrically conductive element comprises an electrically conductive paste provided in a cavity being located at least partially within the at least one electrically insulating layer structure and in thickness direction in between said two electrically conductive layer structures electrically connecting one to each other. Said cavity is in lateral direction at least partially delimited by a lateral wall of the electrically insulating layer structure, wherein said lateral wall has at least two opposed portions with different inclinations relative to a contacting plane between the electrically insulating layer structure and one of said two electrically conductive layer structures and with respect to a thickness direction of the stack.

A component carrier according to the first aspect of the present invention, with the cavity delimited by a lateral wall of the electrically insulating layer structure, wherein the lateral wall comprises at least two opposite portions with different inclinations relative to a contact plane between the electrically insulating layer structure and one of the two electrically conductive layer structures with respect to a thickness direction of the stack, can be achieved, in particular, by the choice of a proper initial shaping of the cavity in the at least one electrically insulating layer structure and a proper amount of conductive paste provided therein.

This can be explained in particular by the fact that, with a suitable shape of the cavity and a correspondingly suitable amount of filling of the cavity with the electrically conductive paste, when the stack, comprising the at least two electrically conductive layer structures and the sandwiched at least one electrically insulating layer structure, is formed, in particular during lamination, by applying pressure, and preferably also by pressure on said at least two electrically conductive layer structures towards the at least one electrically insulating layer structure, the amount of the conductive paste, which preferably occupies a larger volume than that of the initial cavity, can deform the lateral walls of the cavity, wherein the conductive paste can in particular deform the material of the electrically insulating layer structure not yet fully cured.

Due to the limited volume of the cavity, the conductive paste in said cavity may be properly pressed, which can at the same time assure an enhanced amount of conductive material in the occupied volume (due to the pressed conductive material, in particular due to the related pressed conductive particles).

In at least one embodiment, in particular in a preferred embodiment, the cavity is completely filled with the paste, in particular overfilled. Advantageous seems to be filling the cavity with an amount of conductive paste having a volume (Vol-%) of at least 100%, 110%, 120%, 130%, 140% or 150%, but preferably less the 160%, 170%, 180% 190% or 200% of the original cavity volume.

Further, the conductive material, in particular the conductive particles in the conductive paste, can preferably at least partially fuse due to the above mentioned lamination.

In addition, a reliable and dense contact area may be formed between the conductive paste and the respective at least two electrically conductive layer structures.

Also, the freely adaptable shaping of the conductive paste towards the material of the at least one electrically insulating layer structure, can, at least in some cases, provide a stable structure of the resulting electrically conductive element, wherein the resulting conductive paste structure can be provided in particular free from internal tensions, in particular free from residual stresses. In some cases, the conductive material can as well be intermingled with the insulating material forming the cavity into which the paste has been filled.

With the prescribed advantages, a reliable quality of the electrical connection, established by the electrically conductive element which is formed by the electrically conductive paste the cavity is filled with, and therefore a reliable and advantageous component carrier can be provided. In particular, a component carrier comprising an electrically conductive element for electrical interconnection of at least two electrically conductive layer structures of the component carrier can be provided with precise, reliable, and high-quality electrical connections, also with a high connection density, wherein the component carrier may furthermore be manufactured with a low scrap rate.

Due to the different inclinations of the lateral wall, the cavity respectively the electrically conductive element comprises a cross-section geometry which might be advantageous in several situations, and which might in particular reduce the risk of a defective electrical connection.

A component carrier according to the first aspect of the present invention may also be less sensitive to thermal stress and to the influence of shrinkage of one or more parts of the component carrier, in particular already during manufacture, wherein this may in particular be caused by the more stable structure of the electrically conductive element.

As a result, the manufacturing scrap rate may be reduced, in particular the scrap rate because of contacting errors as incomplete, insufficient, or faulty contacting, in particular due to the pressed and/or at least partly fused particles and the resulting enhanced contact area with the respective electrically conductive layer structure. In particular, the occurrence of shearing-off and/or slipping-off of the electrically conductive element within the electrically conductive element and/or at the interface to an adjacent electrically conductive layer structure may be reduced.

Furthermore, the reliability and risk of failure over lifetime of the component carrier may be reduced because of the more stable structure of the electrically conductive element. With a cavity design according to the present invention respectively with a corresponding design of the electrically conductive element resulting directly from the cavity design, in particular the risk of failure of the electrically conductive element within the electrically conductive element and/or at the interface to an adjacent electrically conductive layer structure may be reduced.

The advantages of the present invention are all the more advantageous the more layers the component carrier comprises, in particular if the component carrier comprises a plurality of electrically conductive layer structures, each with an electrically insulating layer between them, and wherein the individual electrically conductive layer structures are correspondingly electrically connected to each other via an electrically conductive element, which is formed in particular by a cavity filled with an electrically conductive paste. In particular, the present invention enables providing and manufacturing of a component carrier in which the individual layers are added one at a time with high quality electrical connections and a low scrap rate.

The reason for this is that in this case in particular, especially in the case of very small dimensions of the electrical contact elements in conjunction with a high dielectric constant (Dk) of the electrically insulating layer structure, under certain conditions, in particular during lamination, more in particular through hot pressing in the manufacturing of the component carrier, the electrically conductive layer structure located further out may deform to a higher extend, in particular shrink more, than the associated inner electrically conductive layer structure which is in electrical contact with the outside. Is the inner electrically conductive layer structure additionally in electrical contact with at least one other electrically conductive layer structure located further in, this effect may be increased. The different shrinkage behavior of the electrically conductive layer structures being electrically connected with each other can cause the electrical contact element to shear-off or slip-off. This may result in a failure or a defect or reduced connection quality of the electrical contact. This can be advantageously counteracted by the present invention, in particular with the special design of the cavity and the conductive paste amount respectively of the electrically conductive element.

"Further out" denotes in the context of the present application in particular a layer arranged nearer to the outer surface of the component carrier or the stack in stacking direction, wherein a "more inner" layer refers in particular to a layer being located nearer to the center or the inner of the component carrier or the stack in stacking direction

In addition, by increasing the quality of the electrical connection between the at least two electrically conductive layer structures, the risk of a negative influence on the performance of the electrical resistance of the electrically conductive element decreases.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from proper art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaO₂, AgAlO₂, LiGaTe₂, AgInSe₂, CuFeS₂, BeO.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface-mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer, or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In the context of the present application, the term "stack" may particularly denote an arrangement of multiple planar layer structures which are mounted in parallel on top of one another. Some of the layer structures of the stack described herein may be stacked directly onto each other, that means with no further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art.

In at least one embodiment, the at least one electrically conductive layer structure of the component carrier comprises at least one of the following group consisting of: copper, aluminum, nickel, silver, gold, palladium, tungsten, and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT), respectively.

In the context of the present application, the term "electrically insulating layer structure" may denote a layer structure which is electrically non-conductive.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres, or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "layer structure" may particularly denote a continuous layer, a patterned layer, or a plurality of non-consecutive islands within a common plane. A layer structure can comprise at least one protruding element such as, for example, one or more solder bumps, copper bumps, pillars, or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

In the context of the present application, the term "electrically conductive element" may particularly denote an element of the component carrier that provides and/or facilitates the transmission of electrical signals, and which is configured to electrically connect various components and/or layer structures within the component carrier. Electrically conductive elements are, for example, conductive traces, pads and vias.

The at least one electrically conductive element of a component carrier according to the first aspect of the present invention may in particular be a small hole in the component carrier which is filled with conductive material for establishing an electrical connection between different layer structures stacked above each other in stacking direction with an insulating layer structure in between. The at least one electrically conductive element may in particular be a via, preferably a via which establishes an electrical connection in thickness direction or stacking direction between at least two electrically conductive layer structures of a stack and/or component carrier.

In the context of the present application, the term "electrically conductive paste" may particularly denote a type of material that is applied in a paste form and is used to create electrically connections within the component carrier, in particular between at least two electrically conductive layer structures. An electrically conductive paste may comprise electrically conductive particles, such as, for example silver, copper, bismuth, and/or carbon particles and/or a combination thereof, wherein the electrically conductive particles may in particular be suspended in a binder or an adhesive medium. The size of the electrically conductive particles may be in the range of 500 nm to 30 µm. The electrically conductive paste may comprise matrix material configured for hosting the electrically conductive particles. In at least one embodiment, in particular in a preferred embodiment, the matrix material may be a polymeric material, in particular an organic polymeric material, for example an (epoxy) resin. Also, a solder paste and/or sinter paste may be an "electrically conductive paste" in the context of the present application.

The electrically conductive paste may have advantageous properties with respect to the present invention, in particular advantageous viscosities, an advantageous curing/sintering behavior and as well advantageous electrically conductivity. In at least one embodiment, the electrical conductivity of the electrically conductive paste may be larger than 5*10⁵ S/m, in particular larger than 10⁷ S/m, for example.

In at least one embodiment of a component carrier according to the present invention the electrically conductive element, in particular the electrically conductive paste, may be deformable, in particular in a state not being cured or not being totally cured. After finishing the component carrier, the electrically conductive element may in particular be non-deformable since the resin of the conductive paste may be (totally) cured. These properties of the electrically conductive element, in particular of the electrically conductive paste, in particular support the above-described advantageous adaptation of the shape of the conductive element during production of the component carrier, in particular the adaptation of the shape of the conductive paste under pressure and/or temperature.

In the context of the present application, the term "cavity" may particularly denote a recess or hollow space having been created within a structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

In the context of the present application, the term "inclination" particularly refers to the inner geometric angle between the lateral wall of the electrically insulating layer structure delimiting the cavity and a base plane (here: the contacting plane), wherein the "inclination" indicates the tilt or slope of the lateral wall relative to the base plane (here the contacting plane) as reference plane. The inclination indicates how much the lateral wall deviates from the contacting plane. The inclination is measured as the inner angle between the inclined lateral wall and the corresponding base plane (here: the contacting plane).

In the context of the present application, the term "contacting plane" may refer in particular to a (virtual) plane delimiting the cavity from above or from below, in particular in thickness direction of the stack. In particular, the term "contacting plane" may refer to a main surface, in particular to an (in theory) ideal planar main surface, of one of the electrically conductive layer structures facing and overlapping the cavity and in particular delimiting the cavity from above or from below. Said surface may in particular be planar. However, this is not mandatory in reality. In particular in a contact area said "contacting plane" may be slightly curved and/or comprise for example one or more dimples or the like.

In at least one embodiment of a component carrier according to the present invention, the lateral wall extends at least partially, in particular completely, in a circumferential direction with respect to an axis extending in thickness direction or stacking direction, thereby surrounding the conductive paste in the cavity in circumferential direction, the electrically conductive paste preferably being completely surrounded.

Thereby, in a very easy manner a defined shape and as a result a defined extension of the electrically conductive element formed from the electrically conductive paste may be achieved. This allows to provide a precise, reliable, and high-quality electrical connection of the electrically conductive layer structures via the electrically conductive element.

In at least one embodiment of a component carrier according to the present invention, each of the two opposing portions is preferably formed by a respective portion of the lateral wall, wherein the two opposing portions may be arranged anywhere in the circumferential direction of the lateral wall, as long as the two portions are facing each other in a lateral direction, in particular in a direction perpendicular to the thickness direction of the stack. However, in at least one embodiment of a component carrier according to the present invention the two opposed portions may preferably only extend over a small part of the circumferential direction of the insulating layer structure.

With these two opposed portions of the lateral wall an advantageous shape of the electrically conductive element may be provided, which might in particular help to reduce the risk of a defective electrical connection, in particular during manufacturing.

In at least one embodiment of a component carrier according to the present invention, the cavity may be filled with electrically conductive paste. Thereby, a very reliable and advantageous electrical connection between the electrically conductive layer structures may be established, in particular an electrical connection which may also significantly contribute to heat dissipation and mechanical strength of the component carrier.

In particular, when the cavity is completely filled with conductive paste material, the lateral wall may delimit a lateral extension of the conductive paste in the cavity in lateral direction, preferably in a radial direction of the cavity, with respect to the thickness direction, in particular over the complete circumference of the cavity. This may in particular have an advantageous effect on the mechanical properties of the component carrier.

In at least one embodiment of a component carrier according to the present invention, the cavity may have a maximum diameter in a range from 0.03 mm to 1 mm, in particular in a range from 0.05 mm to 0.2 mm. With a cavity size in the proposed range precise electrical contacting can be ensured even with a high contacting density.

In at least one embodiment of a component carrier according to the present invention, the at least one electrically insulating layer structure may in particular have a dielectric constant (Dk) in a range from 1.5 to 10, preferably in a range from 2.0 to 5.0. The "dielectric constant (Dk)" (or "relative permittivity") indicates a material's ability to store electrical energy in an electric field. It is defined by the ratio of the permittivity of the dielectric material to the permittivity of free space (vacuum). A dielectric is an insulating material, and the dielectric constant (Dk) of an insulator indicates the ability of the insulator to store electric energy in an electrical field. With an electrically insulating layer structure material as proposed, sufficient electrical isolation can be achieved, and the component carrier can be manufactured in a very easy manner.

In at least one embodiment of a component carrier according to the present invention, the at least one electrically insulating layer structure may in particular have a dissipation factor (Df) in a range from 0.001 to 0.05, preferably in a range from 0.02 to 0.03. The "dissipation factor (Df)" indicates the dielectric losses in the material. With an electrically insulating layer structure material as proposed, sufficient electrical isolation can be achieved, and the component carrier can be manufactured in a very easy manner.

In at least one embodiment of a component carrier according to the present invention said cavity is in thickness direction at least partially delimited by said two electrically conductive layer structures, wherein preferably a first one of the electrically conductive layer structures delimits the cavity at its upper side (from above), and wherein a second one of the electrically conductive layer structures delimits the cavity at its bottom side (from below). Thereby, a very compact and thin component carrier can be provided with precise, reliable, and high-quality electrical interconnections between the at least two electrically conductive layer structures.

In at least one embodiment of a component carrier according to the present invention said two electrically conductive layer structures are electrically connected via said electrically conductive element being arranged in between, in particular with said electrically conductive paste being provided within the cavity. Thereby, a very compact and thin component carrier can be provided with precise, reliable, and high-quality electrical interconnections between the at least two electrically conductive layer structures. In particular, at least one electrically conductive element forms a so-called ZiC, that means a "Z-interconnection", wherein the abbreviation "ZiC" in particular refers to an electrical interconnection within a stack establishing an electrical connection between two parts of the stack in stacking direction (Z-direction), in particular in vertical direction.

In at least one embodiment of the component carrier according to the present invention, the electrically conductive element, in particular the electrically conductive paste, is in contact with a first one of the two electrically conductive layer structures (at least) in a first contact area, and with the second one of the two electrically conductive layer structures (at least) in a second contact area, wherein the first contact area and the second contact area are in particular be located opposed to each other in thickness direction.

Thereby, a very compact and thin component carrier can be provided with precise, reliable, and high-quality electrical interconnections between the at least two electrically conductive layer structures, in particular between two adjacent or neighbored electrically conductive layer structures, in particular with at least one electrically (insulating layer) structure in between.

The electrically conductive element may in particular be in contact, in particular in direct contact, with one of the electrically conductive layer structures, in particular with the first one, at its upper side with respect to thickness direction of the stack, and with the other electrically conductive layer structure, in particular with the second one, at its bottom side. This allows to provide direct connections with the electrically conductive layer structures with the conductive element, in particular with the electrically conductive paste. And if the electrically conductive element is in contact with the electrically conductive layer structures at its upper side and at its bottom side, an advantageous and direct connection of the electrically conductive layer structures can be established which is easy to be manufactured.

In at least one embodiment of the component carrier according to the present invention, an extension of the first contact area, in particular a first length, preferably in a first direction, and an extension of the second contact area, in particular a second length, preferably also in the first direction, are different from each other, wherein in particular one extension is smaller or shorter than the other.

In particular, a first length of a contacting surface between the electrically conductive element and the respective electrically conductive layer structure in the first contact area is different from a second length of a contacting surface between the electrically conductive element and the respective electrically conductive layer structure in the second contact area.

This may in particular be the result of not only the initial shape of the cavity, but also of a proper chosen amount of the conductive paste and of the adaptation of the shape during forming of the stack, in particular during lamination, of the conductive paste in the volume defined by the initial cavity and the adjacent electrically conductive layer structures.

In at least one embodiment of the component carrier according to the present invention, the first direction may in particular extend in a direction perpendicular to the thickness direction of the stack. The second contact area is in particular also extending in the first direction, preferably also extending in a direction perpendicular to the thickness direction of the stack (and therewith also parallel to the first direction).

With such a design of the electrically conductive element the risk of failure or defect or reduced connection quality of the electrical contact may be reduced, in particular because of the optimized adhesion of the conductive paste against the electrically conductive layer structures due to the respective pressure of the paste in the available volume during the stack manufacturing. Under certain conditions and circumstances, this design of the electrically conductive element may in some cases or situations in particular counteract a shear-off or slip-off of the electrically conductive element as it may be caused by different shrinkage behavior of the different parts of the component carrier under thermal load, as it for example may occur during hot-pressing in manufacturing of the component carrier.

In at least one embodiment of the component carrier according to the present invention, said cavity in the insulating layer structure has been created by material removal of the insulating layer structure by using laser means before being filled at least partially, preferably completely, with the electrically conductive paste.

Creating the cavity by material removal, in particular by using laser means, has the advantage that the material of the electrically insulating layer structure at the edge of the cavity is just as homogeneous in its properties as in its other areas. This can be detected, for example, in a micrograph of a cross-section through the component carrier in the area of the electrically conductive element. In the case of a cavity created by material removal, the internal structure of the insulating material (which may in particular comprise, for example, filler material and/or reinforcement fibers inside) is suddenly disrupted by the material removal cut, eventually removing, or leaving the filler material, wherein in particular some fibers may expose inside the cavity.

In particular therein a cavity created by material removal is distinguishable from a molding of a resin on the already existing via, for which in particular the flowing of the resin against said via can be recognized, wherein the flowing of the resin against said via may in particular be recognized in that the composition of the resin, in particular the concentration of its ingredients, for example filler particles, in the zone around the surface interface is at least slightly different from the composition of the resin in the remaining zone of the electrically insulating layer structure resulting in an at least slightly inhomogeneity in this area.

By using laser means for material removal, in a very easy manner further an advantageous cavity with an advantageous cavity geometry and advantageous surface properties can be provided. The laser treatment may positively influence the material forming and delimiting the cavity which may result in advantageous influence of the properties, in particular of the mechanical properties, of the electrical connection to be established by the electrically conductive paste filled into said cavity. For example, by laser treatment, a surface roughness of the treated surfaces may be influenced. This may result in an increase of mechanical connection strength between the electrically conductive paste and the respective surface, enabling an improved and more reliable electrical connection.

In at least one embodiment of the component carrier according to the present invention, in one contact area, in which the electrically conductive element, in particular the conductive paste, is in contact with one of the electrically conductive layer structures and in which the respective electrically conductive layer structure delimits the cavity in thickness direction, in particular in the first contact area or the second contact area, the electrically conductive layer structure comprises a dimple which is facing towards the cavity with its opening.

With such a design of the electrically conductive element the risk of failure or defect or reduced connection quality of the electrical contact may be reduced. Under certain conditions and circumstances, this design of the electrically conductive element may in some cases or situations in particular counteract a shear-off or slip-off of the electrically conductive element as it may be caused by different shrinkage behavior of the different parts of the component carrier under thermal load, as it for example may occur during hot-pressing in manufacturing of the component carrier. In particular the dimple (if designed appropriately), in particular a slight dimple as created by material removal using laser means, can help to reduce the risk of a shear-off or slip-off of the electrically conductive element. By such a dimple in particular the connection strength with the electrically conductive layer structure may be increased and/or connection quality be improved.

In at least one embodiment of the component carrier according to the present invention, the dimple is located at the bottom of the cavity with respect to a material removal direction in particular by laser means. Thereby, the dimple in the component carrier may serve as an indicator of the direction of the focus of the laser by which the cavity has been made, wherein the dimple can in particular indicate that the initial shape of the cavity was slanted and/or generated by laser drilling through the at least one electrically insulating layer structure from the main surface of said structure opposed to said dimple toward the main surface adjacent/closest to said dimple.

In particular, the dimple may be located in one of the at least two electrically conductive layer structures.

Thereby, the risk of failure or defect or reduced connection quality of the electrical contact may further be reduced, since a better adhesion of the electrically conductive paste to the one of the at least two electrically conductive layer structures may be achieved due to a higher surface area created by the dimple.

In at least one embodiment of the component carrier according to the present invention, the dimple is located in the contact area with the smaller extension of the (initial) cavity. This may help to further reduce the risk of failure or defect or reduced connection quality of the electrical contact.

This geometrical feature (the dimple being located in the contact area with the smaller extension of the (initial) cavity) may be created by using a proper or suitable manufacturing process, for example, by a laser drilling process. When a laser drilling process is used, usually a tapered shape of the cavity is created, wherein in particular the smaller length and/or area of the, for example, frustoconically shaped cavity created by the laser means is further away from the laser drilling tool. Since the laser beam may also remove at least a part of the material adjacent to the smaller length and/or area of the frustoconically shaped cavity, here in particular of the of the electrically conductive layer structure being located adjacent to this smaller length and/or area, additional material is removed in an area associated to the contact area with the smaller extension, in particular of the electrically conductive layer structure material. Since this additional material removal is usually characterized by a larger amount of material removal around the center axis or drilling axis, i.e., around the center of the bottom of the cavity, a deepening, in particular a dimple-shaped deepening at the bottom of the cavity may be the result with the dimple being associated to the contact area with the smaller extension.

In at least one embodiment of the component carrier according to the present invention, a surface roughness of the surface of the electrically conductive layer structure in the contact area with the smaller extension and/or of the dimple is smaller than a surface roughness of a surface of the electrically conductive layer structure in the opposed contact area with the larger extension of the contact area.

Thereby, in some cases and under some conditions, an improved mechanical connection in the contact area with the smaller contact area between the electrically conductive layer structure and the electrically conductive element can be achieved. Thereby, the risk of failure or defect or reduced connection quality of the electrical contact can be reduced since the zone around the smaller contact area seems to be more often the source of failure, defects, or reduced connection quality of the electrical contact compared to the larger contact area. The advantageous surface roughness in the contact area with the smaller extension and/or of the dimple can be achieved by using a proper or suitable manufacturing process, for example, (also) by a laser drilling process.

The smaller roughness of the smaller contact area may in particular allow a good, smooth, and reliable electrical connection between the electrically conductive element and the respective electrically conductive layer structure, even when considering the smaller cross-section and/or contact area at the specific electrically conductive element extremity.

Even if due to the smaller surface roughness the adhesion between the two elements in the smaller contact area would decrease, this can be counter-balanced by the higher roughness in the opposed contact area at the other electrically conductive element extremity and eventually of the lateral walls of the cavity, so that overall connection reliability increases.

The electrically conductive layer structure in the opposed contact area with the larger extension of the contact area may in particular be applied by lamination of an electrically conductive layer structure without exposure to a laser beam, resulting in a different, in particular larger surface roughness, compared to the bottom surface of the laser created cavity, in particular to the dimple surface. Laser treatment, in particular laser drilling, may smoothen the surface of the respective area and therefore result in a smaller surface roughness in the contact area associated to the surface of the electrically conductive layer structure with the smaller extension compared to the surface roughness of the surface of the electrically conductive layer structure in the opposed contact area with the larger extension of the contact area.

In at least one embodiment of the component carrier according to the present invention, a surface roughness of the surface of the electrically conductive layer structure in the contact area with the smaller extension and/or of the dimple, is smaller than a surface roughness of a surface of the electrically conductive layer structure surrounding said contact area.

Thereby, the risk of failure or defect or reduced connection quality of the electrical contact may further be reduced. A larger surface roughness of a surface of the electrically conductive layer structure surrounding said contact area may ensure good and reliable contact, in particular adhesion, of the electrically insulating layer structure to the electrically conductive layer structure, in particular in the surrounding contact area, since the larger surface roughness imparting a plurality of connection points to the area of the electrically conductive layer structure and thus the electrically insulating layer structure can easy connect to an adjacent electrically conductive layer structure. Whereas the smaller surface roughness of the electrically conductive layer structure in the contact area may ensure good adhesion of the conductive paste to the electrically conductive layer structure, since due to the physical properties of the material of the conductive paste the conductive paste has an advantageous wettability on surfaces having a roughness smaller than 5 µm.

In at least one embodiment of the component carrier according to the present invention, the stack comprises at least one further cavity being located at least partially within said at least one electrically insulating layer structure and being arranged in stacking direction in between said two electrically conductive layer structures, electrically connecting one to each other, wherein said further cavity is (also) in lateral direction at least partially delimited by a lateral wall of the electrically insulating layer structure, said lateral wall also having at least two opposed portions with different inclinations relative to a contacting plane between the electrically insulating layer structure and one of said two electrically conductive layer structures and with respect to a thickness direction of the stack.

This allows in a very easy and efficient manner to provide a multilayer component carrier having multiple electrical connections between the electrically conductive layer structures, each established by a plurality of electrically conductive elements, which may in particular be formed by an electrically conductive paste filled into said cavities.

Although, the cavities may in particular be created identically, in particular by identical laser removal, in at least one embodiment of the component carrier according to the present invention, the resulting final electrically conductive elements of the component carrier formed by electrically conductive paste filled into said cavities, may in particular differ in size, dimension and shape, in particular at the end of the manufacturing process, in particular after hot-pressing, due to differences in occurred shrinkage or other effects occurred during manufacturing, in particular due to effects occurred during lamination. This applies the more, if the cavities are not distributed respectively arranged regularly in the respective insulating layer structure. However, this may be advantageous with respect to the risk of failure or defect or reduced connection quality of the electrical contact.

In at least one embodiment of the component carrier according to the present invention, the inclination of at least one lateral wall or a portion thereof of the further cavity relative to the contacting plane between the electrically insulating layer structure and one of said two electrically conductive layer structures and with respect to the thickness direction of the stack is different from the inclination of at least one lateral wall or a portion thereof of the first cavity relative to the contacting plane between the electrically insulating layer structure and one of said two electrically conductive layer structures and with respect to the thickness direction of the stack. Different inclination angles of respective electrically conductive elements may indicate that the stack has being subjected to different shear forces and/or stresses during production. Nevertheless, the use of the described manufacturing method may ensure a reliable and straight forward process yielding in vertical through connections having good mechanical properties and electrical conductivity even if different shear forces and/or stresses are apparent at different locations of the component carrier during production and/or are affecting different locations of the component carrier, in particular differently, during production.

In at least one embodiment of the component carrier according to the present invention, said lateral wall has at least partially a specific shape, in particular an at least partially straight shape or an at least partially curved shape. A curved shape may in particular include a convex shape and/or a concave shape, at least partially.

The specific shape of the lateral wall may be the outcome of the adaptation of the conductive paste's shaping and/or deformation towards the cavity walls when forming the stack, preferably arriving at an ideal shape with low internal stresses, in particular with low residual stresses, as well as with an optimal concentration of electrically conductive particles within the conductive paste, also imparted by the specific fillers and resin concentration and distribution composing the at least one electrically insulating layer structure defining the cavity.

With such a design of the electrically conductive element the risk of failure or defect or reduced connection quality of the electrical contact may further be reduced. Under certain conditions and circumstances, this design of the electrically conductive element may in particular better counteract a shear-off or slip-off of the electrically conductive element as it may be caused by different shrinkage behavior of the different parts of the component carrier under thermal load, as it for example may occur during hot-pressing in manufacturing of the component carrier.

In at least one embodiment of a component carrier according to the present invention, at least one lateral wall may comprise a first portion with a first shape along its extension in thickness direction of the stack, and a least a further portion (second portion) arranged in thickness direction in particular adjacent to the first portion, comprising a second shape, e.g., a round or curved shape, in particular a concave shape or a convex shape, wherein the first portion and the second portion may have different shapes. At least one lateral wall may further comprise a third portion or a further portion with another shape. The (specific) shape of at least one portion of the lateral wall may extend at least partially in circumferential direction; in some embodiments completely, i.e., over the complete circumference.

The shape of the lateral wall may in some cases help to further reduce the risk of failure or defect or reduced connection quality of the electrical contact. The shape of the lateral wall may also bring the advantage of imparting an anchor-like structure to the electrically conductive element, since the different shapes of the several portions of a lateral wall of the electrically conductive element, for example, a first portion with a first shape along its extension in thickness direction of the stack, and a second portion arranged in thickness direction in particular adjacent to the first portion with a second shape being different from the first shape, may create indentations and/or protrusions creating a higher surface area for adhesive interaction between the material of electrically insulating layer structure and the electrically conductive element. This can ensure a high mechanical quality of the stack due to an improved mechanical connection of the adjacent electrically conductive layer structures being connected by the electrically conductive element sandwiched in between these conductive layer structures compared to a connection by an electrically conductive element having straight lateral walls without indentations and/or protrusions.

In at least one embodiment of the component carrier according to the present invention, in at least one sectional plane extending parallel to the thickness direction of the stack a cross-section of the cavity and/or of the conductive paste, the cavity is at least partially filled with, may have, at least partially or completely, an irregular quadrangular shape, a parallelogram shape, a slanted shape, or a trapezoidal shape or a combination thereof, wherein the cross-section of the cavity and/or of the conductive paste may in particular have, at least partially or completely, a general trapezoidal shape, a symmetrical(=isosceles) trapezoidal shape, or a perpendicular trapezoidal shape or a combination thereof.

This kind of shape of the cavity and/or of the conductive paste and therewith of the electrically conductive element may in some cases help to further reduce the risk of failure or defect or reduced connection quality of the electrical contact. An at least partially irregular quadrangular shape, in particular a parallelogram shape, may have the advantage of being able to efficiently distribute and/or deflect at least a part of the applied pressure or force during production of the component carrier, since the electrically conductive element may elastically deform without creating a breakage within the electrically conductive element resulting in a reliable electrically connection.

In at least one embodiment of the component carrier according to the present invention, in at least one sectional plane extending parallel to the thickness direction of the stack a cross-section of the cavity and/or of the conductive paste does not show any and/or irregular protrusions of the conductive paste protruding into a structure surrounding the cavity or the conductive paste, wherein the cross section is in particular free of irregular protrusions protruding irregularly into the surrounding structure at at least one of the outer boundaries of the cavity, and/or wherein the cross section is in particular free of irregular protrusions protruding irregularly in a direction normal to the lateral wall into the surrounding structure.

That means in other words, that at least one cross-section through the stack, in particular through the cavity and/or through the conductive paste in at least one sectional plane extending parallel to the thickness direction of the stack, does not show the conductive paste being protruding irregularly into a structure surrounding the cavity, in particular not at one of the outer boundaries of the cavity, and/or preferably not protruding into the insulating layer structure, in particular not in a direction normal to the lateral wall.

This can reduce the risk of faults and defects occurring in the electrical contacting, particularly in the area of the electrical contact element, as the electrical contact element appears to shear off or fail more quickly with such protrusions and react more sensitively to different shrinkage behavior. Accordingly, the risk of shearing-off and/or slipping-off can be reduced and the tolerance to shrinkage can be increased by avoiding such protrusions.

In at least one embodiment of the component carrier according to the present invention, the component carrier comprises at least two sub-carriers, in particular at least a first sub-carrier and a second sub-carrier, each comprising at least one electrically conductive layer structure and/or at least one electrically insulating layer structure, wherein the at least two sub-carriers are stacked one above the other in thickness direction with at least one insulating layer structure in between, and wherein the respective electrically conductive layer structures of the respective sub-carriers stacked one above the other are electrically connected one to each other by at least one electrically conductive element, wherein the electrically conductive element comprises an electrically conductive paste provided in a cavity being located at least partially within the at least one electrically insulating layer structure and in thickness direction in between said two electrically conductive layer structures being electrically connected one to each other, wherein said cavity is in lateral direction at least partially delimited by a lateral wall of the electrically insulating layer structure, said lateral wall having at least two opposed portions with different inclinations relative to a contacting plane between the electrically insulating layer structure and one of said two electrically conductive layer structures and with respect to a thickness direction of the stack.

This allows to provide in a very easy and efficient manner a component carrier comprising a plurality of electrically conductive layer structures, each with an electrically insulating layer between them, and wherein the individual electrically conductive layer structures are correspondingly electrically connected to each other via an electrically conductive element, which is formed in particular by a cavity filled with an electrically conductive paste. In particular, the present invention enables providing and manufacturing of a component carrier in which the individual layers or sub-carriers are added one at a time with high quality electrical connections and a low scrap rate.

An important further advantage is that this allows in particular to manufacture and test the sub-carriers separately before stacking them one above the other. This allows to combine only approved sub-carriers. Thereby overall scrap can drastically be reduced.

With the inventive design of the electrically conductive element the risk of failure or defect or reduced connection quality of the electrical contact may further be reduced. The more layers or sub-carriers a component carrier comprises, the more relevant becomes the quality of the electrical connections and a low scrap rate.

In the context of the present invention the term "sub-carrier" may in particular refer to a subassembly, in particular a sub-stack, comprising at least one electrically conductive layer structure and preferably at least one electrically insulating layer structure, configured to be stacked with other layer structures to a stack of a component carrier according to the present invention. A sub-carrier may form a part of a layer structure or a complete layer within the stack. A sub-carrier may in particular have a specific function. A sub-carrier may, for example, support the main carrier function of the component carrier and may, for example, in particular mechanically strengthen the component carrier. A sub-carrier may in particular be a carrier having a plurality of electrically conductive layer structures and electrically insulating layer structures, wherein in particular at least one electrically insulating layer structure is stacked in between two electrically conductive layer structures in stacking direction, and wherein optionally one or more components can be embedded in the sub-carrier.

Alternatively or in addition, sub-carrier may, for example, comprise the functionality of one or more processors, memories and/or antennas.

A component carrier according to the present invention may comprise a plurality of sub-carriers or sub-stacks, wherein in particular at least two sub-carriers may comprise or have different functionalities or are configured for different purposes. Thereby, a compact and advantageous component carrier may be provided comprising a widespread functionality.

In at least one embodiment of the component carrier according to the present invention, in particular in a preferred embodiment, the component carrier comprises one or more sub-carriers, each sub-carrier in particular comprising a plurality of layer structures, preferably at least two electrically conductive layer structures and at least one electrically insulating layer structure in between, wherein at least two sub-carriers are stacked above each other in stacking direction and are electrically connected one to each other by at least one electrically conductive element, wherein said electrically conductive element comprises an electrically conductive paste provided in a cavity being located at least partially within at least one electrically insulating layer structure in between the respective and electrically connected sub-carriers and in thickness direction in between said two sub-carriers electrically, wherein the conductive element, in particular the conductive paste, is electrically connecting the sub-carriers one to each other. Said cavity is in lateral direction at least partially delimited by a lateral wall of the electrically insulating layer structure, wherein said lateral wall has at least two opposed portions with different inclinations relative to a contacting plane between the electrically insulating layer structure and one of said two sub-carriers and with respect to a thickness direction of the stack.

In one or more embodiments of a component carrier according to the present invention, the prescribed conductive element, comprising an electrically conductive paste and having a shape according to the present invention with different inclinations of its lateral walls, may only be used for electrically connecting at least two sub-carriers one to each other, but not for electrical interconnections within one or more sub-carriers.

In at least one another embodiment of a component carrier according to the present invention, the prescribed conductive element, comprising an electrically conductive paste and having a shape according to the present invention with different inclinations of its lateral walls, may be used for electrically connecting at least two sub-carriers one to each other and/or for electrical interconnections within one or more sub-carriers.

In at least one embodiment of the component carrier according to the present invention, the component carrier further comprises at least one additional sub-carrier, in particular a third sub-carrier, wherein the component carrier preferably comprises two outer sub-carriers and at least one inner sub-carrier, the at least one inner sub-carrier in particular being sandwiched in between the two outer sub-carriers.

Thereby, a compact and advantageous component carrier may be provided comprising a widespread functionality.

In at least one embodiment of the component carrier according to the present invention, a dimple is provided in the contact area in which the electrically conductive element is connected to the electrically conductive layer structure of the at least one inner sub-carrier, wherein the dimple is in particular with its opening facing outwards from the inner sub-carrier towards at least one outer sub-carrier.

With this cavity design according to the present invention respectively with a corresponding design of the electrically conductive element resulting directly from the cavity design, in particular the risk of failure of the electrically conductive element within the electrically conductive element and/or at the interface to an adjacent electrically conductive layer structure may significantly be reduced. By a dimple shaped and arranged like this the negative influence of shrinkage can advantageously be reduced. In particular the risk of the electrical contact element of shearing-off and/or slipping-off can be reduced with such a cavity design. This advantage is all the more advantageous the more layers the component carrier comprises.

In at least one embodiment of the component carrier according to the present invention, the bottom of the cavity is located at the electrically conductive layer structure of the at least one inner sub-carrier, wherein in particular a dimple is located at the bottom of the cavity and therewith at the electrically conductive layer structure of the at least one inner sub-carrier.

Thereby, in particular the risk of the electrical contact element of shearing-off and/or slipping-off can be reduced. This advantage is all the more advantageous the more layers the component carrier comprises. The inventors surprisingly found out, that when the bottom of the cavity is located at the (electrically conductive layer structure of the) at least one inner sub-carrier, the risk of creation an electrically conductive element having bad electrically performance may be reduced compared to the circumstance when the bottom of the cavity is located at the outer sub-carrier, since shearing-off and/or slipping-off have lower influence.

This effect may be enhanced with a dimple shape at the bottom of the cavity due to the advantages the dimple brings as explained above.

In at least one embodiment of the component carrier according to the present invention, the contact area with the smaller extension is located at the electrically conductive layer structure of the at least one inner sub-carrier.

Thereby, in particular the risk of the electrical contact element of shearing-off and/or slipping-off can further be reduced. This advantage is all the more advantageous the more layers the component carrier comprises. Shear forces may be higher at an outer side of the component carrier and/or sub-carrier. Therefore, it may be advantageous when the contact area with a larger extension is located at the electrically conductive layer structure of the at least one outer sub-carrier and consequently the contact area with the smaller extension is located at the electrically conductive layer structure of the at least one inner sub-carrier.

This effect may be enhanced with a dimple shape at the bottom of the cavity located at the electrically conductive layer structure of the at least one inner sub-carrier due to the advantages the dimple brings as explained above.

In at least one embodiment of the component carrier according to the present invention, a surface roughness of the surface of the electrically conductive layer structure in the contact area located at the electrically conductive layer structure of the at least one inner sub-carrier is smaller than a surface roughness of a surface of the electrically conductive layer structure in the opposed contact area at the least one outer sub-carrier.

Thereby, the mechanical strength of the electrical connection may be influenced positively, resulting in reduced risk of failure of the electrically conductive element within the electrically conductive element and/or at the interface to an adjacent electrically conductive layer structure. The component carrier may be created by mechanically fixing, in particular by lamination, outer sub-carriers to the inner sub-carrier. Having a larger surface roughness of a surface of the electrically conductive layer structure in the opposed contact area at the least one outer sub-carrier may ensure to reduce the risk of delamination of the component carrier, since the larger surface roughness imparts and/or assists creating good adhesion between the layers of the stack, in particular the sub-carrier.

This effect may be enhanced with a dimple shape at the bottom of the cavity located at the electrically conductive layer structure of the at least one inner sub-carrier due to the advantages the dimple brings as explained above.

In at least one embodiment of the component carrier according to the present invention, a surface roughness of the surface of the electrically conductive layer structure in the contact area located at the electrically conductive layer structure of the at least one inner sub-carrier is smaller than a surface roughness of a surface of the electrically conductive layer structure surrounding said contact area.

Thereby, the mechanical strength of the electrical connection may be influenced positively, resulting in reduced risk of failure of the electrically conductive element within the electrically conductive element and/or at the interface to an adjacent electrically conductive layer structure. Location of failure may occur outside from the contact area, in particular with a different kind of failure, in particular different from shearing-off and/or slipping-off, resulting in several situations in less critical defects.

Usage of the electrically conductive paste may allow to reliably establish a mechanical and/or electrical connection to an area having the smaller surface roughness, in particular to the contact area located at the electrically conductive layer structure of the at least one inner sub-carrier, whereas a larger surface roughness of the surface of the electrically conductive layer structure surrounding said contact area is needed to ensure good adhesion to the electrically insulating layer structure.

This effect may be enhanced with a dimple shape at the bottom of the cavity located at the electrically conductive layer structure of the at least one inner sub-carrier due to the advantages the dimple brings as explained above.

In at least one embodiment of the component carrier according to the present invention, at least one sub-carrier is a printed circuit board, an interposer, or an IC substrate. Usage of an IC substrate and/ or printed circuit board as a sub-carrier may give the ability to manufacture highly complex component carriers very efficiently using the described method.

In at least one embodiment of the component carrier according to the present invention, at least one cavity of the component carrier has been created by material removal using laser means with a material removal direction from outwards to inwards, in particular resulting in a cavity with a smaller extension of the contact area at the inner side of the cavity respectively of the conductive element, in particular of the conductive paste, and forming the bottom surface of said cavity with respect to a material removal direction.

It has been found by the inventors that thereby in particular the risk of the electrical contact element of shearing-off and/or slipping-off can significantly be reduced. This advantage is all the more advantageous the more layers the component carrier comprises, and/or the smaller a cavity diameter is. The risk of the electrical contact element of shearing-off and/or slipping-off seems also to depend on the material of the electrically insulating layer structure, wherein the prescribed effect may also be all the more advantageous the higher the dielectric constant (Dk) of the electrically insulating layer structure is, which directly correlates with the material of the electrically insulating layer structure. This applies in particular for cavity or via diameters below 0.2 mm and/or an electrically insulating layer structure with a dielectric constant of Dk > 1.5, 1.7, 2.0 or 4.0, as for example the electrically insulating material FR-4 comprises.

In at least one embodiment of the component carrier according to the present invention, at least one lateral wall or a portion thereof of at least one cavity tapers inwards to a center of the component carrier.

It has been found by the inventors that thereby in particular the risk of the electrical contact element of shearing-off and/or slipping-off can significantly be reduced. This advantage is all the more advantageous the more layers the component carrier comprises, and/or the smaller a cavity diameter is. The risk of the electrical contact element of shearing-off and/or slipping-off may in some embodiments (also), in particular at least partly, depend on the material of the electrically insulating layer structure as described above. The prescribed effect may also be all the more advantageous the higher the dielectric constant (Dk) of the electrically insulating layer structure is. This applies in particular for cavity or via diameters below 0.2 mm and/or an electrically insulating layer structure with a dielectric constant of Dk > 1.5, 1.7, 2.0 or 4.0, as for example the electrically insulating material FR-4 comprises.

In at least one embodiment of the component carrier according to the present invention, in at least one sectional plane extending parallel to the thickness direction of the stack a cross-section of at least one cavity and/or of at least one conductive paste has a tapered shape, in particular with the taper being oriented inwards and towards a center of the component carrier.

It has been found by the inventors that thereby in particular the risk of the electrical contact element of shearing-off and/or slipping-off can significantly be reduced. This advantage is all the more advantageous the more layers the component carrier comprises, the smaller a cavity diameter is and/or the higher the dielectric constant (Dk) of the electrically insulating layer structure is. This applies in particular for cavity or via diameters below 0.2 mm and/or an electrically insulating layer structure with a high dielectric constant of Dk >4.0, as for example the electrically insulating material FR-4 comprises.

In the context of the present application the term "tapered" may in particular denote an at least partial inclination to the stacking direction and/or to the main surface of at least one of the contacting plane and/or electrically conductive layer structure delimiting said cavity.

That means in other words, the lateral wall of said cavity may in particular be a tapered wall, which is at least partially inclined to the stacking direction and/or to the main surface of at least one of the components limiting said cavity. The inclination of the tapered lateral wall may be constant over the height of the cavity or may vary.

In at least one embodiment of the component carrier according to the present invention, the concentration of the conductive particles in the conductive paste varies within the conductive paste in the cavity. In particular, the distribution of the electrically conductive particles may vary within the electrically conductive element.

This may result in an advantageous distribution of (different) mechanical and/or electrical properties within the electrically conductive element, in particular within the electrically conductive paste. This may in particular result in portions within the electrically conductive element having even a higher electrically conductivity, since portions with a high particle amount and/or concentration conduct electrically current better because the path of the electrically conduct depends on the amount of connecting and/or contacting particles within the electrically conductive paste. Further, this may also help to reduce the internal stresses on the resulting electrically conductive element.

The prescribed results may in particular be the outcome of the prescribed adaptation of the conductive paste inside the cavity.

Thereby, in particular the risk of failure or a defect in the electrical connection and/or the quality of the electrical connection may be positively influenced (if the distribution is appropriate).

In particular the risk that the electrical contact element may shear-off or slip-off may be reduced if the distribution is appropriate. This advantage is all the more advantageous the more layers the component carrier comprises.

Also, the electrical conductivity may be increased, if the distribution is appropriate, resulting in reduced electrical resistance and losses.

In at least one embodiment of the component carrier according to the present invention, the conductivity of the electrically conductive element differs depending on the location within the conductive element, in particular in thickness direction. During pressing, in particular when additionally applying heat with a temperature above 80°C, in particular when applying temperatures above 100°C, the electrically conductive particles of the electrically conductive paste may sinter together, resulting in agglomerates which may have a higher mechanical stability and/or electrically conductivity compared to a single electrically conductive particle of the electrically conductive paste.

This may result in an advantageous distribution of (different) mechanical and/or electrical properties within the electrically conductive element, in particular within the electrically conductive paste. Thereby, in particular the risk of failure or a defect in the electrical connection and/or the quality of the electrical connection may be positively influenced (if the distribution is appropriate).

In particular the risk that the electrical contact element may shear-off or slip-off may be reduced if the distribution is appropriate. This advantage is all the more advantageous the more layers the component carrier comprises.

Also, the electrical conductivity may be increased, if the distribution is appropriate, resulting in reduced electrical resistance and losses.

In at least one embodiment of the component carrier according to the present invention, the concentration of conductive particles within the conductive paste in the cavity is higher in a core portion of the at least one conductive element, in particular in a cube or square shaped core volume, in particular in a cube or square shaped core volume extending between the two extremities of the at least one conductive element in thickness direction.

This may in particular increase the electrical conductivity between the two electrically conductive layer structures, resulting in reduced electrical resistance and losses.

In the context of the present application the term "core portion" may in particular denote the portion of the conductive element overlapping along the stack thickness direction from one extremity of the conductive element to the opposed extremity of the conductive element.

In a preferred embodiment, the concentration of conductive particles within the conductive paste in the cavity is in particular lower in the perpendicular free portion of the cavity between the two extremities of the at least one conductive element in thickness direction/stacking direction.

In the context of the present application the term "perpendicular free portion" may in particular denote the portion of the conductive element not fully overlapping along the stack thickness direction from one extremity to the opposed extremity of the conductive element.

In some embodiments, this may also positively influence the mechanical properties of the electrically conductive element, in particular its resistance against shearing-off and/or peeling-off.

In at least one embodiment of the component carrier according to the present invention, the concentration of conductive particles within the conductive paste in the cavity is higher on the frontal inclined lateral wall of the cavity, in particular higher than on the rear inclined lateral wall.

In the context of the present application the term "frontal inclined lateral wall" in particular refers to the lateral wall on the left side with respect to a shearing force applied in a direction perpendicular to the stacking direction from this left side to the right side on the conductive element, for example, caused by relative movement of the upper electrically conductive layer structure to the right and relatively to the lower electrically conductive layer structure (which may in particular be moved relatively to the left). In case, the shearing force is applied vice versa, that means from the right to the left, the right lateral wall forms the "frontal inclined lateral wall". This shape of the conductive element may create a preferred path for electrical current transmission, since on the frontal inclined lateral wall the concentration of the electrically conductive particles of the electrically conductive paste may be higher. Nevertheless, the rest of the electrically conductive element may have a mechanical and/or electrically conductive property sufficient for a reliable stability and/or (mechanical or electrical) connection.

In at least one embodiment of the component carrier according to the present invention, said at least one electrically insulating layer structure, in which at least one cavity is located at least partially, comprises a resin with a filling structure within said resin, wherein said cavity in particular exposes at least a portion of said filling structure so that said portion contacts said conductive paste.

This (what can be achieved by material removal only) may in particular positively influence the mechanical properties of the component carrier because of the mechanical intermingling between the exposed filling structure and the conductive paste. This may in particular stabilize/strengthen the shape of the electrically conductive element. As a result, the risk of failure and/or any defect and/or reduced quality of the electrical connection may be reduced. In particular, a higher resistance against shearing-off and/or slipping-off of the electrically conductive element, in particular of the electrically conductive paste may be achieved.

In at least one embodiment of the component carrier according to the present invention, the exposed portion of the filling structure disrupts a profile of the lateral wall of the insulating layer structure delimiting the cavity at least partially.

This (what can be achieved by material removal only) may in particular positively influence the mechanical properties of the component carrier through the formation of irregular profiles/undercuts (due to this disruptions) along the stack thickness direction. This may in particular stabilize/strengthen the shape of the electrically conductive element. The fact that the filling material of the electrically insulating layer structure or, if present, the corresponding reinforcing fibers reach up to the cavity or the electrically conductive element, in particular the electrically conductive paste, has the advantage that the (mechanical) properties of the filling structure can act directly until the electrically conductive element. As a result, the risk of failure and/or any defect and/or reduced quality of the electrical connection may be reduced. In particular, a higher resistance against shearing-off and/or slipping-off of the electrically conductive element, in particular of the electrically conductive paste may be achieved.

In at least one embodiment of the component carrier according to the present invention, the component carrier comprises a plurality of cavities, a plurality of them or each having a profile of the lateral wall of the respective insulating layer structure being disrupted by the respective filling structures, wherein the disrupted profiles of the pluralities of lateral walls may differ one from each other. This may bring the advantage that the plurality of cavities, in particular filled with electrically conductive paste, in connection with the filling material of the electrically insulating layer structure may create a reinforcement network, which may strengthen the overall mechanical stability of the component carrier in thickness direction and/or perpendicular to thickness direction, since the reinforcement network may in particular create a mesh extending over a big area and/or volume, for example, over an area bigger than 30% of the one electrically insulating layer.

Whereas the mesh pitches do not correspond to the pitches of the cavities (resulting in different disrupting profiles) the above mentioned mechanical stability may be enhanced. Thereby, the area between the connected cavities has to be considered. Thereby the physical properties of the component carrier, for example Young's modulus and/or stiffness may be influenced. That means in other words, that one rope of glass fiber and/or one fiber (of the filling structure) may interconnect several electrically conductive elements. Depending on the position of the fiber and the conductive element(s), the size of the intersection(s) may change and therewith the resulting mechanically properties.

In at least one embodiment of the component carrier according to the present invention, the disruption only occurs in thickness direction of the stack in a central area of the respective insulating layer structure. This may bring the advantage of reducing the influence of shearing-off and/or slipping-off of the electrically conductive element, in particular at least in the central area with respect to thickness direction and/or stacking direction, since the electrically conductive element may be mechanically stabilized in the central area by the disruption and therewith more resistant against shearing-off, for example.

In the context of the present application the expression "in a central area" in particular refers to approximately a zone around the middle between the upper side and the bottom side (between the two contact areas) in thickness direction, wherein the middle zone or central preferably extends about 10 % to 75 % of the layer thickness in thickness direction of the surrounding insulating layer structure.

In at least one embodiment of the component carrier according to the present invention, the filling structure comprises stiffening fibers, cloth and/or a fabric.

Thereby, the mechanical properties of the component carrier may positively be influenced. In particular mechanical strength may be increased. Further, thereby the risk of failure of the electrically conductive element within the electrically conductive element and/or at the interface to an adjacent electrically conductive layer structure may be reduced.

In at least one embodiment of the component carrier according to the present invention, the profile of the lateral wall is disrupted by exposed fibers protruding inside the cavity, wherein in particular at least some of the exposed fibers penetrate or protrude into the conductive paste in the cavity. Some of the exposed fibers may in particular penetrate the external/liquified metal or resin of the conductive paste, which may in particular be the outcome of the adaptation of the shape of the conductive paste during manufacturing.

This may in particular positively influence the mechanical properties of the component carrier, and in particular stabilize/strengthen the shape of the electrically conductive element. As a result, the risk of failure and/or any defect and/or reduced quality of the electrical connection may be reduced. In particular, a higher resistance against shearing-off and/or slipping-off of the electrically conductive element, in particular of the electrically conductive paste may be achieved.

In at least one embodiment of the component carrier according to the present invention, the electrically conductive paste comprises electrically conductive particles, wherein in particular a plurality of the electrically conductive particles are or comprise metal particles.

Preferably, the conductive paste comprises at least two different metals, and/or at least one binding component, in particular a resin.

Thereby, advantageous electrical conductivity can be achieved. By using metal particles, mechanical strength of the electrically conductive element, in particular of the electrically conductive paste, may be increased, resulting in a reduced risk of failure and/or any defect and/or reduced quality of the electrical connection.

In at least one embodiment of the component carrier according to the present invention, the particles of the electrically conductive paste are at least partially located between the exposed fibers, in particular the electrically conductive particles.

This may in particular positively influence the mechanical properties of the component carrier, and in particular stabilize/strengthen the shape of the electrically conductive element, since the particles of the electrically conductive paste may replace other material between the exposed fibers, which does not contribute to mechanical properties. This may result in an overall higher stability in the area and/or volume where the particles are located between the exposed fibers. As a result, the risk of failure and/or any defect and/or reduced quality of the electrical connection may be reduced. In particular, a higher resistance against shearing-off and/or slipping-off of the electrically conductive element, in particular of the electrically conductive paste may be achieved.

In at least one embodiment of the component carrier according to the present invention, the particles of the electrically conductive paste are at least partially welded and/or sintered one to each other, in particular after final curing and/or hot-pressing, in particular after finishing of a lamination process of the component carrier.

This may in particular positively influence the mechanical properties of the component carrier, and in particular stabilize/strengthen the shape of the electrically conductive element. As a result, the risk of failure and/or any defect and/or reduced quality of the electrical connection may be reduced significantly. In particular, a higher resistance against shearing-off and/or slipping-off of the electrically conductive element, in particular of the electrically conductive paste may be achieved. The resulting conductive element may also have a higher total conductivity because of the welded and/or sintered particles. This can be explained by the fact that the electrically insulating material between the electrically conductive particles is at least partially displaced and/or removed (in particular by vaporization and/or outgassing), especially under pressure and temperature, which results in a higher concentration of conductive particles. Consequently, a higher relative local electrical conductivity per volume can be achieved.

In at least one embodiment of the component carrier according to the present invention, the electrically conductive paste comprises Cu, Sn, or an ally thereof and/or Al, Ni, Ti, W, Ag, Bi, Co, Zn, Mo, Cr, Mn, or an alloy thereof. The use of a plurality of elements, in particular comprising tin or bismuth may lower the melting point of the material of the electrically conductive paste and thus may save energy during the welding process, since lower temperature could be applied.

With such a paste, advantageous electrical conductivity can be achieved, in particular combined with suitable mechanical behavior, in particular with sufficient resistance against shearing-off and/or slipping-off of the electrically conductive element.

In at least one embodiment of the component carrier according to the present invention, the electrically conductive paste is free of Cd and/or Pb.

This allows to provide a component carrier free of the substances Cd and Pb hazardous to health. Further, a component carrier can be provided which enables easy and environmental-friendly recycling.

A method according to the second aspect of the present invention for manufacturing a component carrier comprises at least the following steps:
- providing at least one insulating layer structure and at least a first electrically conductive layer structure, wherein the at least first electrically conductive layer structure is in particular arranged at one of the outer main surfaces of the insulating layer structure,
- creating a cavity at least partially in the insulating layer structure, in particular from the outer surface of the insulating layer structure facing away from the electrically conductive layer structure inwards and towards the electrically conductive layer structure, preferably by using laser means,
- filling said cavity at least partly, preferably completely, with an electrically conductive paste,
- providing at least a second electrically conductive layer structure,
- forming a stack such that the at least one electrically insulating layer structure is stacked in between the first and second electrically conductive layer structures, thereby arranging the cavity with the electrically conductive paste in it in thickness direction in between said two electrically conductive layer structures, and electrically connecting the at least two electrically conductive layer structures one to each other by the electrically conductive paste forming an electrically conductive element,

wherein the resulting cavity is in lateral direction at least partially delimited by a lateral wall of the electrically insulating layer structure,
said lateral wall having at least two opposed portions with different inclinations relative to a contacting plane between the electrically insulating layer structure and one of said two electrically conductive layer structures and with respect to a thickness direction of the stack.

With a method according to the second aspect of the present invention, a component carrier with the advantages described above can be manufactured and therewith provided. In particular, a component carrier can be provided with a reliable quality of the electrical connection, established by the electrically conductive element which is formed by the electrically conductive paste the cavity is filled with. In particular, the method enables manufacturing of a component carrier comprising an electrically conductive element for electrical interconnection of at least two electrically conductive layer structures of the component carrier with precise, reliable, and high-quality electrical connections, also with a high connection density, wherein the component carrier may furthermore be manufactured with a low scrap rate.

Due to the different inclinations of the lateral wall, the cavity respectively the electrically conductive element comprises a cross-section geometry which might be advantageous in several situations, and which might in particular reduce the risk of a defective electrical connection.

In at least one embodiment of a method according to the present invention, the insulating layer structure material is in particular provided as prepreg, preferably in a so-called "B-Stage" or as a "B-stage material". In the context of the present application the term "B-stage" refers in particular to an intermediate stage of resin curing in the prepreg material. The B-stage may in particular represent a partially cured state of the resin, where it is solid but still tacky and pliable. This state allows the prepreg to be handled, cut, and laid up in a mold or lamination stack, where it will undergo further curing to reach its final, fully cured state, the so-called "C-stage".

This "B-stage" in particular supports the adaptation of the shape of the conductive material, in particular of the conductive paste, during forming the stack, in particular under pressure and temperature.

In at least one embodiment of a method according to the present invention, the electrically connecting/electrical connection may be achieved by applying pressure and temperature, thereby in particular causing the prescribed adaption of the conductive element, in particular of the conductive paste, and/or the sintering of the electrically conductive paste (in particular of at least some of its particles) and finally forming the electrical connection. This may preferably be performed in an additional method step, which may preferably also include final curing of the electrically insulating layer structure.

In at least one embodiment of the method according to the second aspect of the present invention, the at least one insulating layer structure and the at least first electrically conductive layer structure are in particular provided as parts of a first sub-carrier, wherein the second electrically conductive layer is provided as a part of a second sub-carrier. At least the electrically conductive layer structure of the first sub-carrier may be provided and/or arranged at one of the outer main surfaces of the insulating layer structure of the respective sub-carrier.

This allows in particular to manufacture and test the sub-carriers separately before stacking them one above the other. This allows to combine only approved sub-carriers. Thereby overall scrap can drastically be reduced.

In at least one embodiment of the method according to the second aspect of the present invention, further at least a third sub-carrier comprising at least one further electrically conductive layer structure is provided and being stacked with the first and the second sub-carriers in thickness direction, in particular such that the resulting component carrier comprises two outer sub-carriers and at least one inner sub-carrier, the at least one inner sub-carrier is in particular sandwiched in between the two outer sub-carriers.

This allows to provide in an easy manner a multilayer component carrier with precise, reliable, and high-quality electrical connections, also with a high connection density, wherein the component carrier may furthermore be manufactured with a low scrap rate.

In at least one embodiment of the method according to the second aspect of the present invention, at least one cavity of the component carrier is created by material removal using laser means with a material removal direction from outwards to inwards with respect to the component carrier, in particular resulting in a cavity with a smaller extension of the contact area at the inner side of the cavity and forming the bottom surface of said cavity with respect to a material removal direction.

It has been shown that electrical contact elements made of electrically conductive paste, which are located in a cavity which has been introduced into the electrically insulating layer structure from the outside inwards, in particular if this results in a cavity having a smaller extension of the contact area at the inner side of the cavity at the bottom surface of said cavity, are significantly more tolerant of shrinkage which occurs during hot-pressing, and as a result the scrap rate and the risk of faulty electrical contacts may significantly be reduced.

In at least one embodiment of a method according to the present invention, at least the first sub-carrier may temporarily comprise a further layer on the surface facing away from the electrically conductive layer structure, wherein this further layer structure may in particular serve as a (temporarily) protective layer structure for the electrically insulating layer structure, and which is removed at the latest before stacking with the second electrically conductive layer structure or a second sub-carrier comprising the second electrically conductive layer structure.

Thereby, the risk of unwanted adherence of foreign material particles during manufacturing can be reduced or in particular avoided. Thereby, good adhesion to the electrically conductive layer structure can be ensured which is required for establishing of a high-quality electrical connection between the electrically conductive layer structures.

In the context of the present application, the term "protective layer structure" may in particular denote a layer structure which is in particular configured to prevent a surface, to which the protective layer structure has been applied to, from changing one or more of its characteristic properties within a defined timeframe under defined conditions.

A protective layer structure may in particular be, for example, a layer structure which may be applied to at least one exposed portion of a layer structure for the time being until an electric connection is established.

A component carrier assembly according to the third aspect of the present invention comprises a component carrier according to the first aspect of the present invention and/or a component carrier manufactured using a method according to the second aspect of the present invention, and at least one further part.

The preferred embodiments presented with reference to a component carrier according to the first aspect of the present invention and its advantages apply correspondingly to a method according to the second aspect of the present invention, and to a component carrier assembly according to the third aspect of the present invention as well and vice versa.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.

### SHORT DESCRIPTION OF THE DRAWINGS

The aspects of the present invention defined above, and further aspects of the invention are apparent from the examples, will now be explained in more detail by way of preferred examples and with reference to the accompanying, but not limiting, drawings. The accompanying drawings merely present some embodiments of the present invention. Modifications to these embodiments are possible without departing from the scope of the present invention as defined in the claims. Functionally identical components are provided with the same reference signs for ease of understanding, in particular for simplified recognition, even if they are or may be designed differently, whereby differences may lie in particular in the dimensions, geometry and/or shape as well as in the material and/or their location within the component carrier.

The drawings show:
- **Fig. 1:**: a component carrier as known from prior art,
- **Fig. 2:**: a cross-section through a component carrier as known from prior art in the area of an electrically conductive element which lacks reliability of the electrical connection due to an insufficient electrical connection in at least one contact region caused by an insufficient amount of conductive paste, as a result of which no sufficient compression of the paste and no sufficient deformation of the paste can be achieved and therefore no sufficient electrical contacting,
- **Fig. 3:**: a first embodiment of a component carrier according to the first aspect of the present invention,
- **Fig. 4:**: a schematic illustration of a first embodiment of a manufacturing process according to the second aspect of the present invention for manufacturing of a first embodiment of a component carrier according to the present invention,
- **Fig. 5a:**: a schematic illustration of a second embodiment of a manufacturing process according to the second aspect of the present invention for manufacturing of a preferred embodiment of a component carrier according to the present invention, and
- **Fig. 5b:**: a schematic illustration of the resulting component carrier manufactured according to Fig. 5a.
- **Fig. 6:**: a second embodiment of a component carrier according to the first aspect of the present invention,
- **Fig. 7:**: a third embodiment of a component carrier according to the first aspect of the present invention,
- **Fig. 8:**: a fourth embodiment of a component carrier according to the first aspect of the present invention,
- **Fig. 9a:**: a schematic illustration of an exemplary shape of the electrically conductive element of a component carrier according to the present invention,
- **Fig. 9b:**: in top view a schematic illustration of a section of a component carrier according to the present invention with congruent electrically conductive layer structures,
- **Fig. 9c:**: in top view a schematic illustration of a section of a component carrier according to the present invention with non-congruent but at least partly overlapping electrically conductive layer structures,
- **Fig. 10:**: a further schematic illustration of an exemplary shape of the electrically conductive element of a component carrier according to the present invention,
- **Fig. 11a** to **11c:**: further schematic illustrations of different examples of possible shapes of the electrically conductive element of a component carrier according to the present invention,
- **Fig. 12:**: a cross-section through an embodiment of a component carrier according to the present invention in the area of an electrically conductive element with a first possible configuration of the electrically conductive element (similar to that one schematically illustrated in Fig. 3),
- **Fig. 13:**: a schematic illustration of an example of a core area of the electrically conductive element in which the particle concentration of the conductive particles of the conductive paste may be higher,
- **Fig. 14:**: a cross-section through a further embodiment of a component carrier according to the present invention in the area of an electrically conductive element with a further possible configuration of the electrically conductive element, wherein the configuration of the conductive element corresponds to Fig. 13,
- **Fig. 15:**: a cross-section through a further embodiment of a component carrier according to the present invention in the area of an electrically conductive element with a further possible configuration of the electrically conductive element,
- **Fig. 16** to **26:**: cross-sections through different embodiments of component carriers according to the present invention in an area of an electrically conductive element with further possible configurations of the electrically conductive element,
- **Fig. 27:**: a scanning electron micrograph of a section through an embodiment of a component carrier in a transition region of the electrically conductive element and the electronically insulating layer structure, wherein the electrically insulating layer structure comprises glass fibers, and
- **Fig. 28** to **33:**: further cross-sections through further different embodiments of component carriers according to the present invention in an area of an electrically conductive element with further possible configurations of the electrically conductive element.

### DETAILED DESCRIPTION

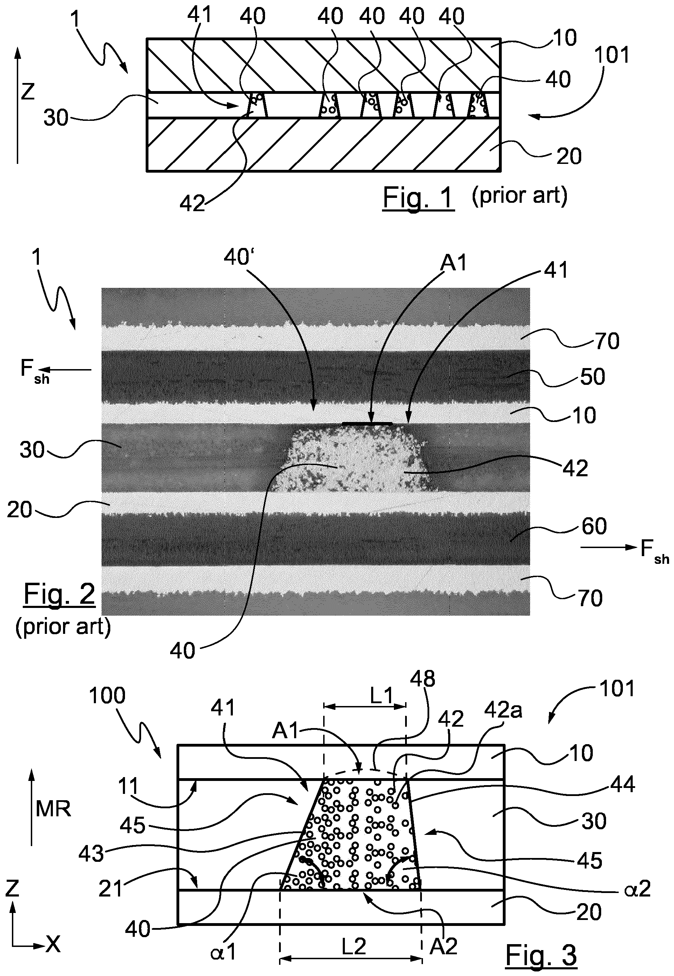

**Fig. 1** shows a component carrier 1 as known from prior art, wherein this component carrier 1 comprises a stack 101 in this example having two electrically conductive layer structures 10 and 20 which are stacked one above each other in thickness direction or stacking direction Z with an electrically insulating layer structure 30 in between. The electrically conductive layer structures 10 and 20 are connected via electrically conductive elements 40, so-called "vias" 40, each being formed by an electrically conductive paste 42 being provided in cavities 41, wherein in this example the cavities 41 are completely filled with the electrically conductive paste 42. All cavities 41 have a symmetrical, frustoconical shape and have been created by laser drilling, wherein the material removal has taken place in direction from the bottom electrically conductive layer structure 20 towards the upper electrically conductive layer structure 10.

**Fig. 2** shows a cross-section through a component carrier 1 as known from prior art in the area of an electrically conductive element 40. This component carrier 1 is in principle buildup similarly to the component carrier as illustrated in Fig. 1. In contrast to the component carrier 1 illustrated in Fig. 1, this component carrier additionally comprises a few more layer structures 50 and 70 at the upper side and as well 60 and 70 at the bottom side, wherein the layer structures 50 and 60 are electrically insulating carrier structures and the layer structures 70 are further layer structures 70, in particular also electrically conductive layer structures for electrical connection of the component carrier one with component or other parts outside of the component carrier 1.

As can be clearly seen in Fig. 2, the component carrier 1 lacks reliability of the electrical connection (see 40') in a first contact area A1 due to an insufficient electrical connection 40' in the contact region A1. The insufficient electrical connection 40' is in this case caused by an insufficient amount of conductive paste 42 filled into the cavity 41, wherein the amount of the conductive paste 42 was not well-adapted to the cavity design. This led to an insufficient compression of the paste 42 during manufacturing of the component carrier 1 and no sufficient deformation of the paste 42 and no sufficient adaptation of the shape of the conductive element 40 was achieved. Thereby, no sufficient electrical contacting was established by the electrically conductive element 40 formed of the paste 42.

As can be clearly seen in Fig. 2, the electrically conductive element 40 fails to completely electrically connect the upper electrically conductive layer structure 10 over its complete extension perpendicular to stacking direction Z.

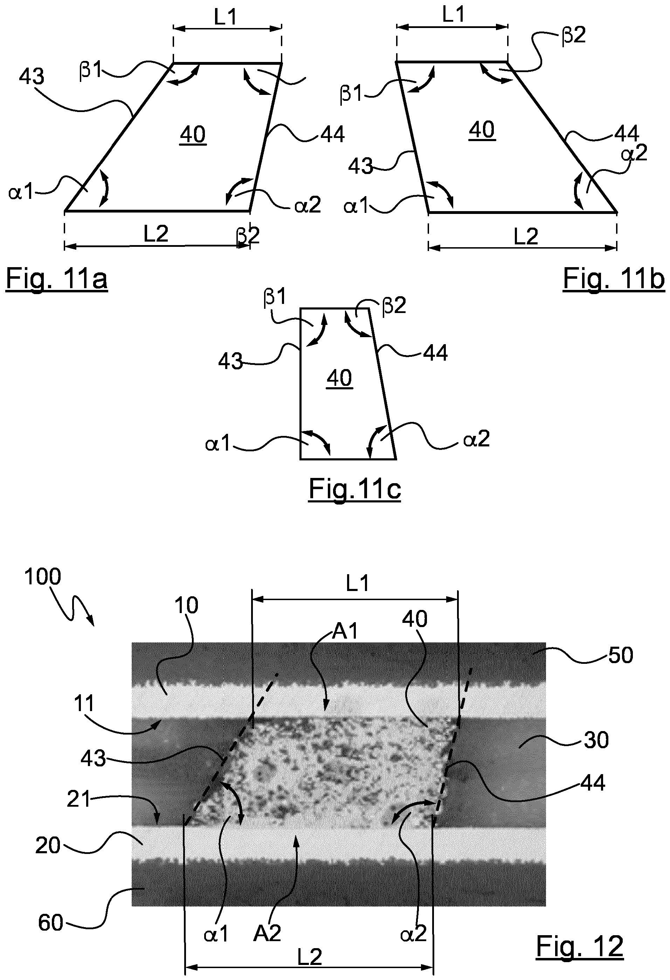

As a result, the electrical contact is only established in a small contact area A1 and therewith insufficient. Only in the area A1 an upper part of the electrically conductive element 40 is electrically connected with the electrically conductive layer structure 10. The result is an electrical connection not fulfilling the requirements, for example having a higher electrical conductivity, for example at least 2 times higher, in particular 10 times higher, compared to electrically conductive elements 40 fulfilling the requirements for example as shown in Fig. 3 or Fig. 12.

This failure pattern may in particular occur, if the electrically conductive layer structures 10 and 20 are electrically connected one to each other by small vias 40, in particular by vias 40 having small diameters (i.e. diameters in a range from 15 µm to 500 µm, in particular of less than 0.3 mm) and/or if the electrically insulating layer structure 30 has a dielectric constant Dk >1.5, 1.7, 2.0 or 4.0 (e.g. a high dielectric constant of Dk >4.0) and/or if a shrinkage or a shearing force Fₛₕ of the outer layer structures 50, 60, 70 exceeds a threshold which may be tolerated from the electrically conductive element 40.

**Fig. 3** shows an example of a component carrier 100 according to the first aspect of the present invention which has a reduced risk of occurrence of the above-described connections/conduction failures. It has been found by the inventors of the present invention that with a specific design of the electrically conductive element 40, respectively with a specific design and/or manufacturing of the cavity 41 into which the electrically conductive paste 42 is later brought in, in particular with a proper amount, the risk of the occurrence of this defect or failure pattern can significantly be reduced. It was in particular found, that the risk of failure could significantly be reduced when the cavity 41 is completely filled with the paste 42, in particular overfilled. Advantageous seems to be filling the cavity 41 with an amount of conductive paste having a volume (Vol-%) of at least 100%, 110%, 120%, 130%, 140% or 150%, but preferably less the 160%, 170%, 180% 190% or 200% of the original cavity volume.

This example of a component carrier 100 according to the present invention comprises a stack 101 with in this illustration only two electrically conductive layer structures 10 and 20, which are stacked one above the other in stacking direction respectively thickness direction Z with an electrically insulating layer structure 30 in between. The electrically conductive layer structures 10 and 20 are mechanically and/or electrically connected one to each other by the electrically conductive element 40, which is formed by an electrically conductive paste 42 which is provided in cavity 41. The cavity 41 is located completely within the electrically insulating layer structure 30 and is extending in thickness direction Z between the two electrically conductive layer structures 10 and 20.

The cavity 41 is in lateral direction X delimited by a lateral wall 45 of the electrically insulating layer structure 30, wherein the lateral wall 45 is formed by the inner wall of the hole or recess forming the cavity 41 extends completely in a circumferential direction around the electrically conductive paste 42. The lateral wall 45 has two opposed portions 43 and 44, which have according to the present invention different inclinations α1 and α2 relative to a contacting plane 21 and between the electrically conductive layer structure 20 and the electrically insulating layer structure 30 with respect to thickness direction Z of the stack 101.

Lateral wall 45, in particular at least the opposed portions 43 and 44, have a specific shape, in this example in particular a straight shape, i.e., they are at least partially, in particular over their complete length in thickness direction Z, straight or linear.

Contrary to the illustration in Fig. 3, the shape of the lateral wall 45 has not mandatorily to be constant in thickness direction Z, rather it may vary in other embodiments.

The lateral wall may have in particular different portions with different shapes in thickness direction and/or as well in circumferential direction. One or more portions may for example have a straight shape and/or one or more portions may have an irregular shape or a curved shape, in particular a convex or concave shape and/or combinations thereof.

The electrically conductive element 40, in particular the electrically conductive paste 42, is in (electrical) contact with electrically conductive layer structure 10 in a first contact area A1 at the contacting plane 11, and also with the electrically conductive layer structure 20 in the second contact area A2 at its contacting plane 21. The two contact areas A1 and A2 are located opposed to each other in thickness direction Z. As it is apparent from Fig. 3, in this example the first contact area A1 is located at the upper side of the electrically conductive element 40 and the second contact area A2 is located at the bottom side of the electrically conductive element 40.

In the example illustrated in Fig. 3, the first contact area A1 and the second contact area A2 are extending in a first direction which in this example corresponds to lateral direction X, wherein an extension of the first contact area A1 (here its length L1) is smaller than an extension (here length L2) of the second contact area L2. Alternatively, the extension of the first contact area A1 (here its length L1) may be similar, in particular the same, as the extension of the second contact area A2 (here its length L2), or the extension of the first contact area A1 (here its length L1) may be larger than the extension (here length L2) of the second contact area L2.

The electrically conductive element 40 is, as already mentioned above, formed from an electrically conductive paste 42 with which the cavity 41 in the electrically insulating layer structure 30 has been filled, wherein in this example cavity 41 is filled completely. Additionally or alternatively, at least a part of the electrically conductive element 40, may at least partially be filled with other material compared to the electrically conductive paste 42, for example with resin being free from electrically conductive particles and/or gas.

Preferably, the conductive paste 42 is free of cadmium (Cd) and lead (Pb) and comprises electrically conductive particles (not indicated herein with reference sign).

In the embodiments shown in the present application, a plurality of the electrically conductive particles comprises metal particles 42a, in particular particles made of copper (Cu). Additionally or alternatively, the electrically conductive paste 42 may comprise particles comprising Sn and/or Ag and/or Bi. In an embodiment, the electrically conductive particles may comprise a particle size smaller than 400 µm, in particular in the range between 400 nm and 300 µm. Preferably the electrically conductive particles may have a round shape, for example a spherical shape or an elliptical shape, and/or the electrically conductive particles may have a polymodal size distribution. Alternatively, the electrically conductive particles may have a monomodal size distribution or a size being in the range between 50 nm and 500 µm. In an example, the electrically conductive paste may comprise an electrically conductive particle loading larger than 65 w%, in particular larger than 80 w%.

The cavity 41 has (before it has been filled by the conductive paste 42) been created by material removal in material in a material removal direction MR by using laser means. As symbolically indicated by the dotted line in Fig. 3, in the contact area A1 the contacting plane 11 formed by the bottom main surface of the electrically conductive layer structure 10 is preferably not ideally planar, but rather comprises a slight dimple 48 which is facing towards the cavity 41 with its opening. Thereby, the connection strength with the electrically conductive layer structure 10 can be increased and connection quality can be improved.

Although, the dimple 48 is illustrated at the upper side of electrically conductive element 40 in Fig. 3, with respect to the material removal direction MR the dimple 48 is located at the bottom of the cavity 41.

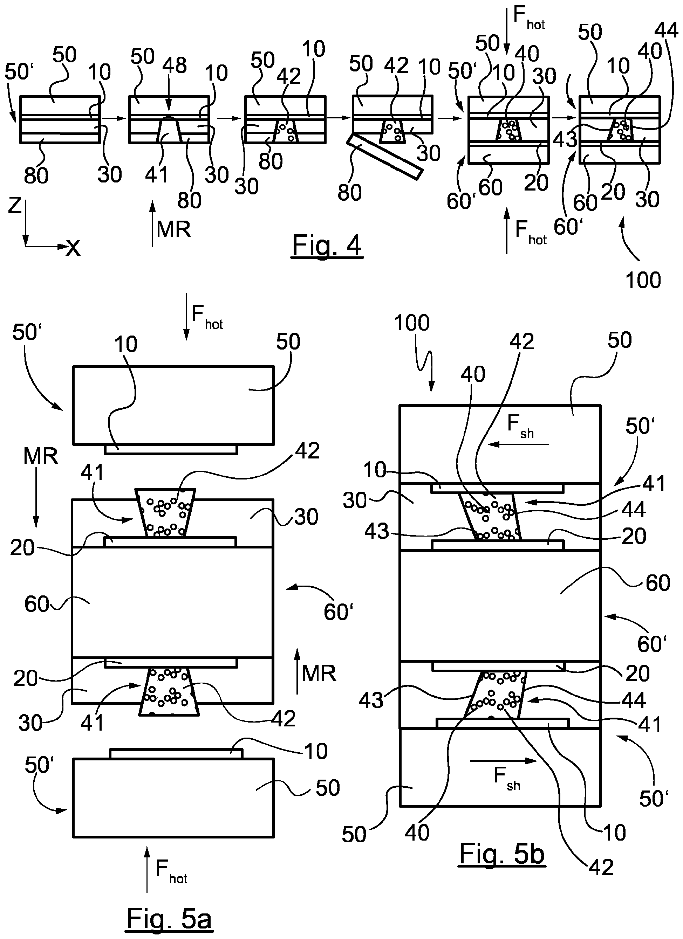

**Fig. 4** shows a schematic illustration of a preferred embodiment of a manufacturing process according to the second aspect of the present invention for manufacturing of a preferred embodiment of a component carrier 100 according to the present invention, wherein in a first step the electrically insulating layer structure 30 and the electrically conductive layer structure 10 are provided. In this example the electrically insulating layer structure 30 the electrically conductive layer structure 10 are part of a first sub-carrier 50' further comprising a carrier layer structure 50 (also being made of electrically insulating material) and a protective layer structure 80 applied onto the electrically insulating layer structure 30. The electrically conductive layer structure 10 is arranged at an outer main surface of the insulating layer structure 30.

In a next step, a cavity 41 is created, in particular by laser means, for example by laser drilling, preferably using a CO₂ laser or an UV laser. The cavity 41 is in particular created by material removal in a material removal direction MR from the outer surface of the electrically insulating layer 30 facing away from the electrically conductive layer structure 10 inwards and towards said electrically conductive layer structure 10, i.e., from the outer surface of the protective layer 80 inwards towards the electrically conductive layer structure 10.

Therein, the cavity 41 is created such that it preferably tapers towards the electrically conductive layer structure 10 and has a smaller extension in lateral direction at its inner side forming the bottom of the cavity 41 compared to its extension (in particular its diameter or a length in lateral direction) at its outer side.

In the next step, cavity 41 is filled with electrically conductive paste before in a further step the optionally provided protective layer 80 is removed. In an alternative embodiment, the protective layer 80 may be removed first, before the cavity is filled with the electrically conductive paste 42.

In this example, the cavity 41 comprises also a slight dimple 48 at its bottom which contributes to the establishment of a high-quality electrical connection between the electrically conductive layer structure 10 and the conductive paste 42 the cavity 41 is filled with.

In a further step, the second electrically conductive layer structure 20 is provided and stacked with the first sub-carrier 50' in order to form the stack and finally the component carrier 100. In this example, the second electrically insulating layer structure 20 is provided as part of a second sub-carrier 60', also further comprising a carrier structure layer 60 made of electrically insulating material.

The first sub-carrier 50' and the second sub-carrier 60' are preferably stacked one above each other in stacking direction Z such that the electrically insulating layer structure 30 is sandwiched in between the two electrically conductive layer structures 10 and 20 in order to enable the electrical connection of the electrically conductive layer structure 10 and 20 by the electrically conductive paste 42 the cavity 41 is filled with.

By applying pressure and preferably also heat, indicated by hot-pressing force Fₕₒₜ, in particular by hot-pressing, the several layer structures 10, 20 and 30 are laminated together and the electrical connection between the electrically conductive layer structures 10 and 20 is established via the electrically conductive paste 42, wherein the electrically conductive element 40 is formed. In this process step, at least some of the conductive particles of the conductive paste 42, in particular in case of metal particles, may be welded and/or sintered together. Thereby, the strength of the electrical connection, in particular of the conductive element 40, can be increased.

The cavity 41 respectively the resulting conductive element 40 is in lateral direction delimited by the electrically insulating layer structure 30, in particular by its lateral wall, wherein the lateral wall comprises at least two opposed portions with different inclinations (not indicated with reference sign in this figure for ease in favor of better clarity) as in detail described above with respect to a component carrier according to the first aspect of the present invention.

**Figs. 5a** shows a schematic illustration of a second embodiment of a manufacturing process according to the second aspect of the present invention for manufacturing of a preferred embodiment of a component carrier 100 according to the present invention, wherein in this example the component carrier 100 is made of three sub-carriers 50', 60' and 50', in particular of an inner sub-carrier 60' comprising a carrier layer 60, two electrically conductive layer structures 20 and two electrically insulating layer structures 30 arranged at the outer sides of the sub-carrier 60', and two outer sub-carriers 50', each comprising a carrier layer structure 50 and one electrically conductive layer structure 10.

As described above, also first the cavities 41 are created by material removal in material removal direction MR using laser means, wherein in the cavities 41 are then filled with an electrically conductive paste 42.

In a further step, the sub-carriers 50', 60' and 50' are stacked one above the other such that each of the electrically insulating layer structures 30 is sandwiched in between the respective two electrically conductive layer structures 10 and 20 in order to enable an electrical connection via the conductive paste 42 in between.

Finally, in a hot-pressing step the sub-carriers 50', 60' and 50' are laminated together and the electrically conductive elements 40 are formed.

**Fig. 5b** shows a schematic illustration of the resulting component carrier 100 manufactured according to Fig. 5a. Both cavities 41 respectively both resulting conductive elements 40 are in lateral direction delimited by the surrounding electrically insulating layer structure 30, in particular by its lateral wall, wherein the lateral wall comprises at least two opposed portions 43, 44 with different inclinations as in detail described above with respect to a component carrier according to the first aspect of the present invention, but not indicated with reference sign in favor of better clarity.

It has been found by the inventors that creating at least one cavity 41 by material removal with a material removal direction MR from outwards to inwards with respect to the component carrier 100, in particular resulting in a cavity 41 with the smaller extension of the contact area at the inner side of the cavity 41 and therewith at the inner side of the component carrier 100, may significantly reduce the risk of defects and/or failures of the connection element 40. In particular, the risk of shearing-off and/or slipping-off may significantly be reduced by creating the cavity 41 with material removal direction MR from outwards to inwards.

It may in particular be advantageous, if at least one cavity and/or at least one conductive element 40 comprises a tapered shape, in particular with the taper being orientated with its smaller diameter towards the center of the component carrier and which the larger diameter outwards.

Similarly to the illustration in Fig. 1, in at least one embodiment of a component carrier according to the present invention, the component carrier may further comprise at least one further cavity 41 and/or at least one further electrically conductive element 40 formed by an electrically conductive paste 42 and as described above.

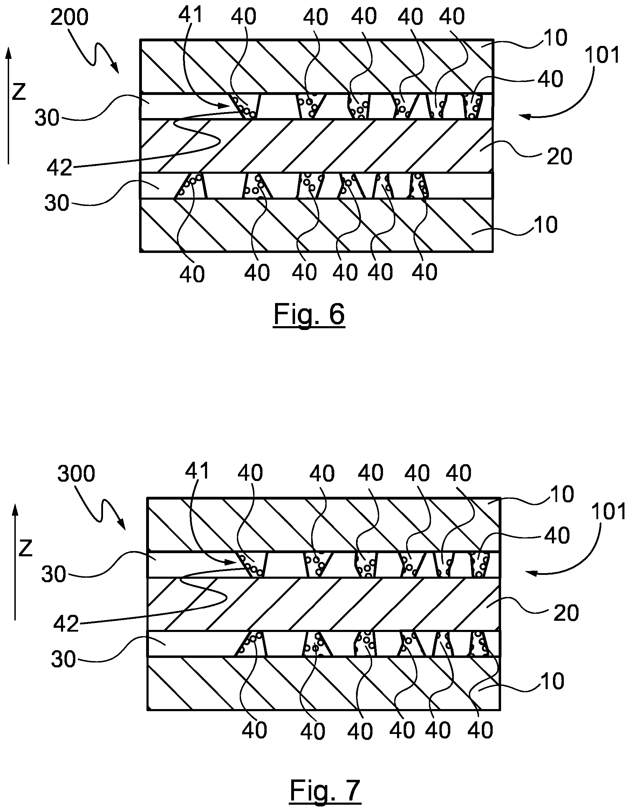

At least one further cavity 41 and/or electrically conductive element 40 may be located at least partially within the same electrically insulating layer structure 30 and also being arranged in stacking direction Z in between the two electrically conductive layer structures 10 and 20. At least one further cavity 41 and/or electrically conductive element 40 may also be at least partially delimited by a lateral wall 45 of the electrically insulating layer structure 30 in lateral direction X may also have at least two opposed portions 43 and 44 having different inclinations α1 and α2 or β1 and β1 relative to a contacting plane 11, 21. This is exemplarily shown in **Figs. 6** and **7****.**

**Fig. 6** shows a second embodiment of a component carrier 200 according to the first aspect of the present invention, and **Fig. 7** shows a third embodiment of a component carrier 300 according to the first aspect of the present invention, each comprising a plurality of cavities 41 and a plurality of conductive elements 40 located within the electrically conductive layer structure 30 and connecting two electrically conductive layer structures 10, 20 one to each other.

The conductive elements may be arranged aligned (in flush) one above the other in the several insulating layer structures 30, as exemplarily and schematically illustrated in Fig. 7. Alternatively, they may be arranged with a lateral offset or a lateral shift in a direction perpendicular to stacking direction, as exemplarily and schematically illustrated in Fig. 6. Also, a combination of these arrangement options is possible in a component carrier according to the present invention.

In addition or alternatively, at least one further cavity 41 or at least one further electrically conductive element 40 may be located in another insulating layer structure.

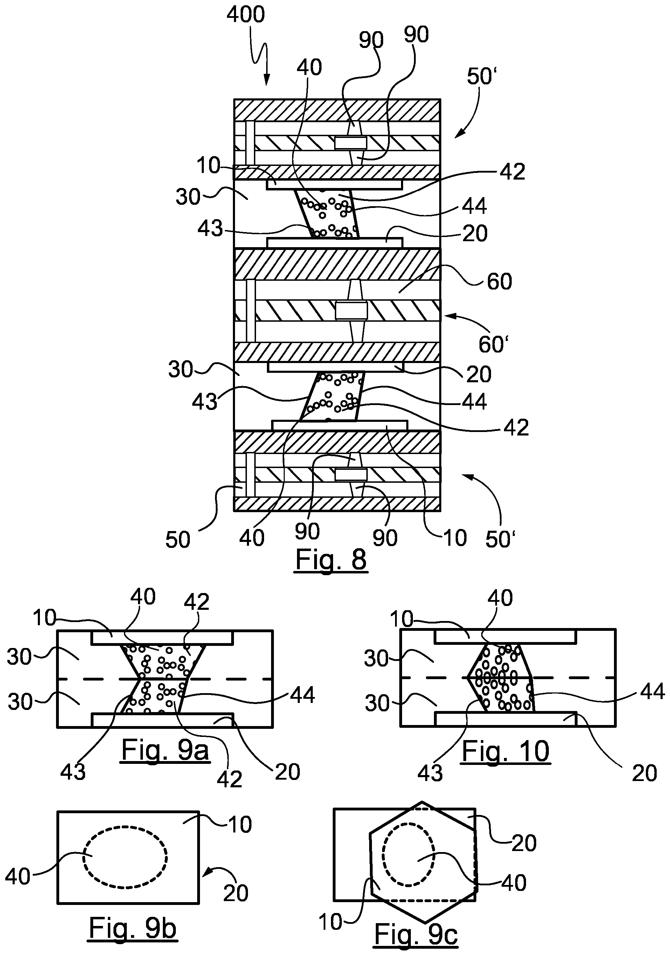

**Fig. 8** shows a fourth embodiment of a component carrier 400 according to the first aspect of the present invention, wherein this component carrier 400 is similar to the component carrier 100 described with respect to Figs. 4, 5a and 5b. However, this example of a component carrier 400 comprises multi-layer sub-carriers 50', 60', wherein in this example only the electrical interconnections between the sub-carriers 50', 60' are made with conductive elements 40 formed of conductive paste 42 according to the present invention. The other electrical interconnections within the several sub-carriers 50', 60' are in this example plated vias 90. Alternatively, one or more via may also be established with conductive elements 40 formed of conductive paste 42 according to the present invention.

The conductive elements 40 of a component carrier according to the present invention may in particular comprise different shapes, sizes, and volumes. This is symbolically shown in the different embodiments of component carriers 100 to 400 and the figures presented in this application. Several of the possible shapes and geometries are explained in more detail in the following.

**Fig. 9a** shows a schematic illustration of an exemplary shape of the electrically conductive element 40 of a component carrier according to the present invention, wherein in this embodiment the conductive element 40 has an "hour-glass" shape, in particular an asymmetric or irregular hour-glass shape.

Further, the electrically insulating layer structure is a double-layer structure, formed from two electrically insulating layer structures 30 stacked one above the other during manufacturing.

The upper insulating layer structure 30 may for example be mechanically connected to the upper electrically conductive layer structure 10 and stacked simultaneously with the lower electrically conductive layer structure 20 and the lower insulating layer structure 30. And the lower electrically insulating layer structure 30 may for example be mechanically connected to the lower electrically conductive layer structure 20 and simultaneously stacked with the upper electrically conductive layer structure 10 and the upper electrically insulating layer structure 30.

The conductive element 40 may also be formed from two parts: of a first amount of paste 42 filled into a cavity in the upper insulating layer structure 30, and from a second amount of paste 42 filled into a cavity in the lower insulating layer structure 30.

This allows to increase flexibility in the design and/or manufacturing of a component carrier according to the present invention.

**Fig. 10** shows a further schematic illustration of an exemplary shape of the electrically conductive element 40 of a component carrier according to the present invention, which is similar as to that one illustrated in Fig. 9a, but wherein the conductive element 40 of this embodiment comprises a hexagonal shape, in particular an asymmetric or irregular hexagonal shape, instead of an hour-glass shape. The creation of the electrically conductive element 40 as shown in **Fig. 9a** and/or **Fig. 10** may ensure a reliable electrical and/or mechanical connection, even if the electrically conductive layer structures 10, 20 are not congruent and/or not exactly overlapping in stacking direction.

**Fig. 9b** shows in top view a schematic illustration of a section of a component carrier according to the present invention being configured similar to that one illustrated in Fig. 9a having congruent (= same form, same position, and same alignment shape and 100% overlapping) electrically conductive layer structures 10, 20 (electrically insulating layer structures 30 are not shown), electrically connected via schematically illustrated electrically conductive element 40 sandwiched in between.

**Fig. 9c** shows in top view a schematic illustration of a section of an alternative component carrier according to the present invention with non-congruent (different shape and/or different position and/or different alignment/orientation) but at least partly overlapping electrically conductive layer structures 10, 20 (electrically insulating layer structures 30 are also not shown), electrically connected via schematically illustrated electrically conductive element 40 sandwiched in between, wherein in this embodiment the upper electrically conductive layer structure 10 comprises a hexagonal shape, and wherein the lower electrically conductive layer structure 20 comprises a rectangular shape.

**Figs. 11a** to **11c** show different examples of possible shapes of the electrically conductive element 40 of a component carrier 100 according to the present invention, wherein Fig. 11a and Fig. 11b each show a conductive element 40 with an irregular quadrangular shape, in particular with an irregular trapezoidal shape. The example of the electrically conductive element 40 illustrated in Fig. 11a is tilted to the right, wherein the electrically conductive element 40 exemplarily illustrated in Fig. 11b is tilted to the left.

Fig. 11c shows an electrically conductive element 40 having a rectangular or perpendicular trapezoidal shape with perpendicular inner angles α1, β1 (i.e., α1 = 90° and β1 = 90°). In an alternative embodiment, instead of angles α1, β1 respectively inclinations α1, β1, also angles α2 and β2 respectively the corresponding inclinations may be perpendicular (i.e., α2 = 90° and β2 = 90°).

As it is apparent from Figs. 11a to 11c, not only the inner angles α1 and α2 at the bottom side of contact element 40 defining the inclinations α1 and α2 relative to the contacting plane 21 (cf. Fig. 3) of electrically conductive layer structure 20 are different from each other, but also the inner angles β1 and β2 defining inclinations β1 and β2 relative to the other contacting plane 11 (cf. Fig. 3) of the electrically conductive layer structure 10 may be different from each other.

In at least one other embodiment, cavity 41 respectively the electrically conductive element 40 may alternatively have a parallelogram shape, a slanted shape, or a substantially trapezoidal shape (however not an ideally trapezoidal shape to ensure the different inclinations α1, α2 resp. β1, β2). In an example, the inner angles α1, α2, β1, β2 may be in the range between 35° to 145°, in particular between 45° to 135°.

**Fig. 12** shows a photo of a cross-section through a real embodiment of a component carrier 100 according to the present invention in the area of an electrically conductive element 40 with a preferred configuration of the electrically conductive element 40, wherein the dotted lines and the arrows have been added in order to emphasize the different inclinations α1 and α2. The configuration of component carrier 100 illustrated in Fig. 12 corresponds to the configuration of the component carrier 100 illustrated in Fig. 3, which has been explained in detail above.

Additionally, Fig. 12 also show layer structures 50 and 60, which are electrically insulating carrier structures 50, 60 made from an electrically insulating material.

Fig. 12 further shows that the metal particles of the electrically conductive paste 42 can at least be partially welded and/or sintered one to each other, wherein the concentration of the conductive particles in the conductive paste 42 can vary within the cavity 41.

As a result of the inhomogeneous distribution of the conductive particles within the conductive element 40, the conductivity of the electrically conductive element 40 can differ depending on the location with the conductive element 40, in particular in thickness direction Z.

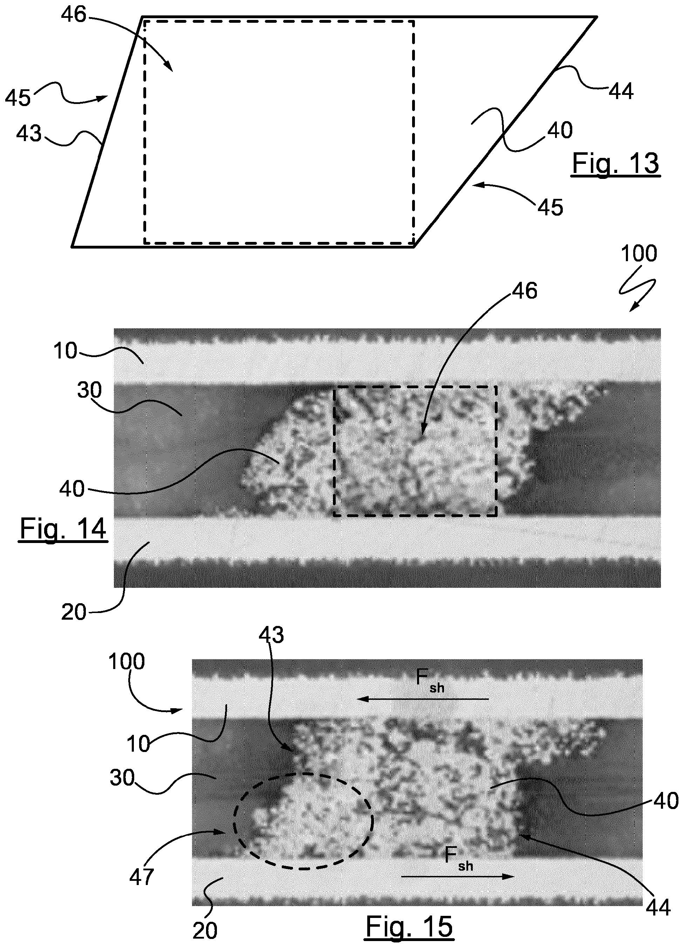

In some embodiments the concentration of the conductive particles within the conductive paste 40 in the cavity 41 may be higher in a core area what is illustrated in **Figs. 13** and **14****,** wherein **Fig. 13** shows a schematic illustration of an example of a core area 46 of the electrically conductive element 40 in which the particle concentration of the conductive particles of the conductive paste is higher.

Said core area 46 may in particular have a cube or square-shaped or a cylindrically shaped core volume 46, in particular a cube or square-shaped core volume (46) extending between the two extremities of the conductive element 40 thickness direction Z, i.e., a cube or square-shaped core volume 46 extending between the two electrically conductive layer structures 10, 20 (cf. Fig. 14) electrically connected by the electrically conductive element 40.

In a preferred embodiment, the concentration of conductive particles within the conductive paste in the cavity is in particular higher in a "perpendicular free portion" of the cavity between the two extremities of the at least one conductive element in thickness direction/stacking direction, i.e., in particular in that portion within the conductive element 40 not being limited in stacking direction by one of the lateral walls 45 or a portion 43, 44 thereof, wherein in this embodiment the perpendicular free portion also forms the core area 46 of the conductive element 40.

**Fig. 14** shows a photo of a cross-section through a real embodiment of a component carrier 100 according to the present invention in the area of an electrically conductive element 40 corresponding to Fig. 13, wherein the dotted square has been added in order to emphasize the cube-shaped core area 46 with a higher density of electrically conductive particles within the electrically conductive element 40 respectively the electrically conductive paste 42.

**Fig. 15** shows a photo of a cross-section through a further real embodiment of a component carrier 100 according to the present invention in the area of an electrically conductive 40 element with a further possible configuration of the electrically conductive element 40. In this example, the concentration of the conductive particles is higher on the frontal inclined lateral wall 47 of the cavity 41, in particular at one extremity, in particular higher than on the rear inclined lateral wall 44, due to the higher shifting of the electrically conductive paste 42 toward the frontal inclined lateral wall 47 during the hot-pressing, wherein in order to emphasize the area with the higher density of electrically conductive particles within the electrically conductive element 40 the dotted ellipse has been added.

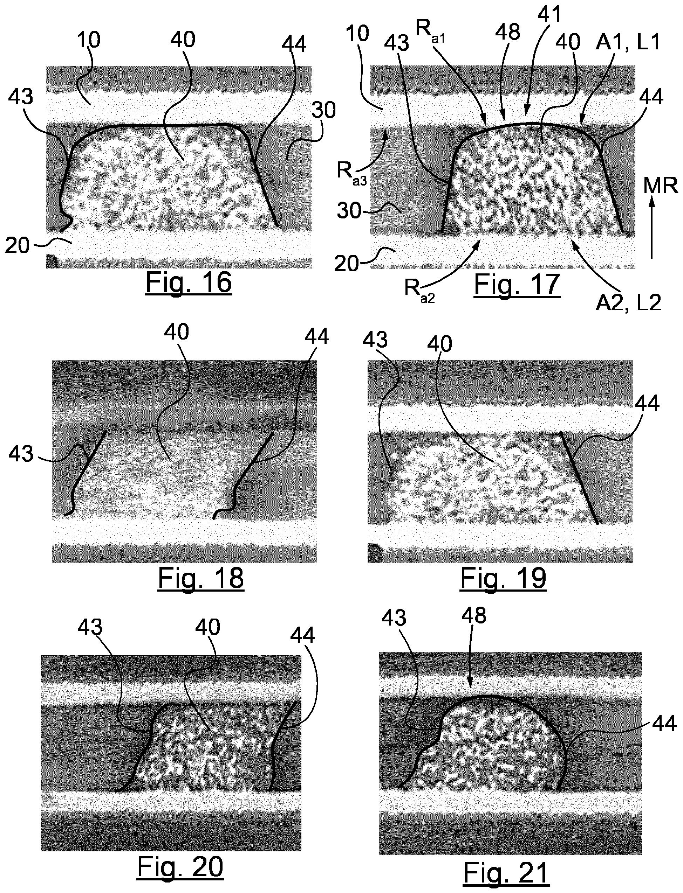

**Fig. 16** to **26** and **28** to **33** show photos of cross-sections through different real embodiments of component carriers 100 according to the present invention in an area of an electrically conductive element 40 with further possible configurations of the electrically conductive element 40, in particular with different shapes and configurations of the lateral wall 45 (cf. Fig. 3) respectively the interface zones between the electrically conductive element 40 and the surrounding layer structures 10, 20 and 30, wherein in order to emphasize the differences between the embodiments in some photos additional lines (solid and/or dotted) have been added.

**Fig. 16****,** for example, shows an embodiment with the conductive element 40 having a curved shape lateral wall portion 43 with different curvatures, wherein the opposed lateral wall portion 44 is substantially straight.

**Fig. 17** shows an embodiment with a cavity 41 respectively a conductive element 40 with a dimple 48 at the bottom of the cavity 41 in a material removal direction MR.

From this photo further different surface roughnesses Rₐ₁, Rₐ₂ and Rₐ₃ are visible, wherein in this example a first surface roughness Rₐ₁ of the surface of the electrically conductive layer structure 10 in the contact area A1 with the smaller extension L1 and/or of the dimple 48 is smaller than a second surface roughness Rₐ₂ of the surface of the electrically conductive layer structure 20 in the opposed contact area A2 with the larger extension L2 of the contact area A2. Alternatively (in another embodiment), the first surface roughness Rₐ₁ of the surface of the electrically conductive layer structure 10 in the contact area A1 may be similar, in particular the same, as, or larger than the second surface roughness Rₐ₂ of the surface of the electrically conductive layer structure 20 in the opposed contact area A2 with the larger extension L2 of the contact area A2.

Further, the first surface roughness Rₐ₁ of the surface of the electrically conductive layer structure 10 in the contact area A1 with the smaller extension L1 and/or of the dimple 48 is smaller than a third surface roughness Rₐ₃ of the surface of the electrically conductive layer structure 10 surrounding said contact area A1. Alternatively (in another embodiment), the first surface roughness Rₐ₁ of the surface of the electrically conductive layer structure 10 in the contact area A1 may be similar, in particular the same, as, or larger than third surface roughness Rₐ₃ of the surface of the electrically conductive layer structure 10 surrounding said contact area A1.

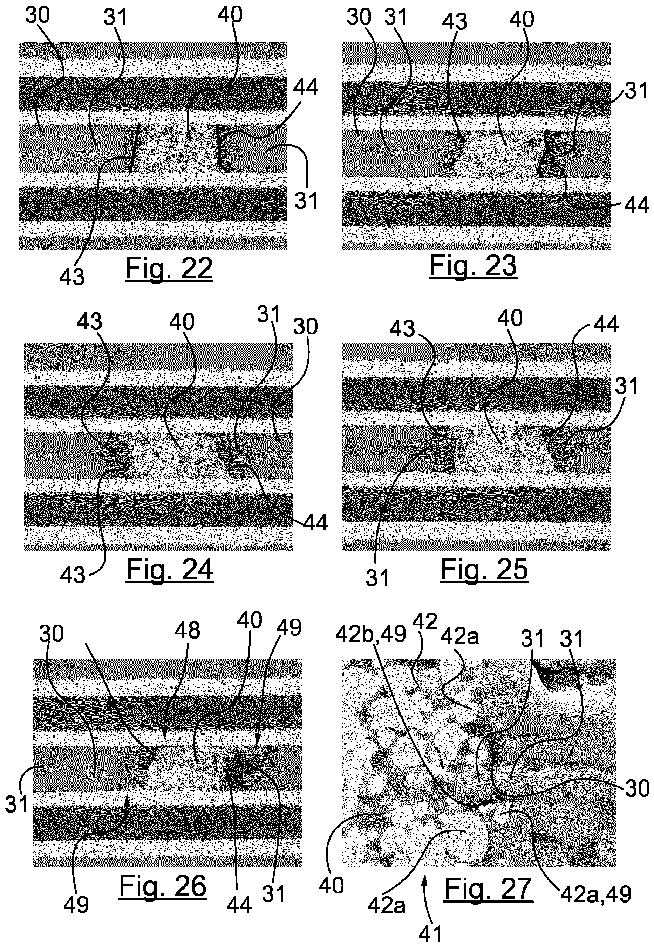

Some of the photos show that the electrically insulating layer structure 30, in which the cavity 41 is located, may comprise a resin with a filling structure 31 within said resin, e.g. reinforcement or stiffening fibers, cloth or fabric or the like, wherein the cavity 41 exposes at least a portion of said filling structure 31 so that said portion of the filling structure 31 contacts said conductive paste 42, see for example the photos in **Figs. 22** to **29** and **33** showing fibers 31 as filling structure 31.

The filling structure 31, in particular in case of fibers 31, may penetrate or protrude into the conductive paste 42 in the cavity 41, i.e., the filling structure 31 may in particular protrude or penetrate into the conductive element 40. Therein, the filling structure 31 in particular may penetrate or protrude such into the conductive element 40 that some of the particles of the electrically conductive paste 42 are finally located in between the exposed filling structure 31, in particular in between the exposed fibers 31.

**Fig. 22** shows exemplarily a conductive element 40 with a lateral wall portion 44 having a slanted shape.

**Fig. 27** shows a scanning electron micrograph of a section through an embodiment of a component carrier in a transition region of the conductive element 40 and the electronically insulating layer structure 30, wherein the electrically insulating layer structure comprises glass fibers 31. From this image the protrusion 49 of the conductive paste 42 with its metal particles 42a and the matrix material 42b (here a resin), surrounding the metal particles 42a, into the electrically insulating layer structure 30 and the deformation of the paste 42 and the adaptation of the shape of the conductive element 40, and also the resulting penetration of the fibers 31 into the cavity 41 with the conductive element 40 (the paste 42) and thereby disrupting the lateral wall of the conductive element 40 is apparent. Figs. 27 also shows the metal particles 42a of the conductive paste 42 being at least partially located between the fibers 31 of the filling structure 31 of the electrically insulating layer structure 30.

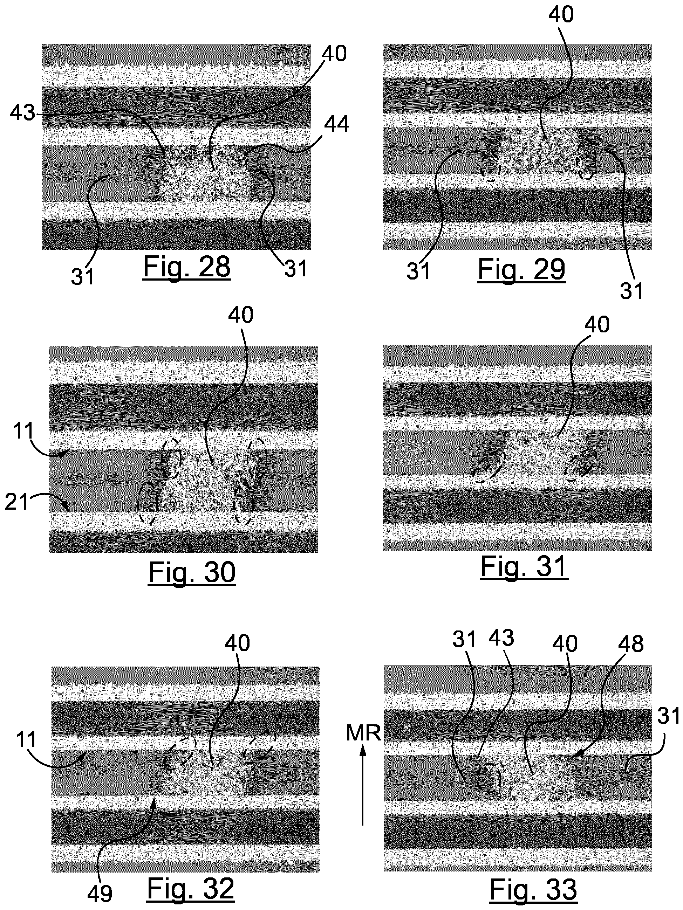

**Fig. 28** shows exemplarily a conductive element 40 with a substantially trapezoidal shape, wherein **Fig. 32****,** for example, shows exemplarily a conductive element 40 having a substantially parallelogram shape.

In some of the shown real embodiments, the exposed portion of the filling structure 31 disrupts a profile of the lateral wall 45 respectively of one of the opposed lateral wall portions 43, 44 of the insulating layer structure 30 delimiting the cavity 41 at least partially, see for example **Fig. 26** (here lateral wall portion 44 is disrupted by the fibers 31) or **Fig. 33** (here lateral wall portion 43 is disrupted by the fibers 31).

Some of the real embodiments show the electrically conductive paste 42 protruding into the surrounding electrically insulating layer structure 30, in particular adjacent to one of the electrically conductive layer structures 10, 20, see for example reference sign 49 in **Figs. 26**.

Some embodiments of the component carrier 100 according to the present invention may comprise a plurality of cavities 41, each having a profile of the lateral wall 45 of the respective insulating layer structure 30 being disrupted by the respective filling structures 31, wherein the disrupted profiles of the pluralities of lateral wall 45 may in particular differ one from each other.

Since the filling structure 31 is substantially located in the central area of the insulating layer structure 30 with respect to the thickness direction Z, in particular if the filling structure 31 is made of or comprises fibers 31 as filler material, the disruption of the lateral wall profile in particular only occurs also in this central area.

Implementation of the invention is not limited to the preferred embodiments shown in the figures and described above. Instead, a multiplicity of variants is possible which use the solutions shown and the principle according to the invention, whose scope is defined by the appended claims.

### LIST OF REFERENCE SIGNS

- 1: component carrier as known from prior art

- 100,.., 400: component carrier according to the present invention
- 101: stack
- 10, 20: electrically conductive layer structure
- 11, 21: contacting plane
- 30: electrically insulating layer structure
- 31: filling structure
- 40: electrically conductive element, via
- 40': defect / failure in electrical connection or conductive element
- 41: cavity
- 42: electrically conductive paste
- 42a: electrically conductive (metal) particles
- 42b: matrix material of the conductive paste (e.g. resin)
- 43, 44: portion of the lateral wall
- 45: lateral wall
- 46: core area, in particular cube-shaped volume
- 47: frontal inclined lateral wall
- 48: dimple
- 49: protrusion
- 50, 60: carrier layer structure (insulating layer structure)
- 50': first sub-carrier
- 60': second sub-carrier
- 70: further layer structure
- 80: protective layer structure
- 90: plated via

- α1: first inclination
- α2: second inclination
- β1: third inclination
- β2: fourth inclination
- A1: first contact area
- A2: second contact area
- Fₕₒₜ: hot-pressing force
- Fₛₕ: shrinking / shearing force
- L1: first length
- L2: second length
- MR: material removal direction
- Rₐ₁, Rₐ₂, Rₐ₃: surface roughness
- X: lateral direction, first direction
- Z: thickness direction (Z), stacking direction

## Claims

1. A component carrier (100, 200, 300, 400), comprising a stack (101), said stack (101) comprising a plurality of electrically conductive layer structures (10, 20) and at least one electrically insulating layer structure (30),
wherein the at least one electrically insulating layer structure (30) is stacked in between at least two electrically conductive layer structures (10, 20),
wherein the at least two electrically conductive layer structures (10, 20) are electrically connected one to each other by at least one electrically conductive element (40),
wherein said electrically conductive element (40) comprises an electrically conductive paste (42) provided in a cavity (41) being located at least partially within the at least one electrically insulating layer structure (30) and in thickness direction (Z) in between said two electrically conductive layer structures (10, 20) electrically connecting one to each other,
wherein said cavity (41) is in lateral direction (X) at least partially delimited by a lateral wall (45) of the electrically insulating layer structure (30),
said lateral wall (45) having at least two opposed portions (43, 44) with different inclinations (α1, α2) relative to a contacting plane (11, 21) between the electrically insulating layer structure (30) and one of said two electrically conductive layer structures (10, 20) and with respect to a thickness direction (Z) of the stack (101).

2. The component carrier (100, 200, 300, 400) according to claim 1, wherein the electrically conductive element (40), in particular the electrically conductive paste (42), is in contact with a first one of the two electrically conductive layer structures (10, 20) in a first contact area (A1), and with the second one of the two electrically conductive layer structures (10, 20) in a second contact area (A2),
wherein the first contact area (A1) and the second contact area (A2) are in particular located opposed to each other in thickness direction (Z).

3. The component carrier (100, 200, 300, 400) according to claim 2, wherein an extension of the first contact area (A1), in particular a first length (L1), preferably in a first direction (X), and an extension of the second contact area (A2), in particular a second length (L2), preferably also in the first direction (X), are different from each other, wherein in particular one extension is smaller than the other.

4. The component carrier (100, 200, 300, 400) according to claim 2 or 3, wherein in one contact area (A1, A2), in which the electrically conductive element (40), in particular the conductive paste (42), is in contact with one of the electrically conductive layer structures (10, 20) and in which the respective electrically conductive layer structure (10, 20) delimits the cavity (41) in thickness direction (Z), in particular in the first contact area (A1) or the second area, the electrically conductive layer structure (10, 20) comprises a dimple (48) which is facing towards the cavity (41) with its opening.

5. The component carrier (100, 200, 300, 400) according to claim 3 or 4, wherein a surface roughness (Rₐ₁) of the surface of the electrically conductive layer structure (10) in the contact area (A1) with the smaller extension (L1) and/or of the dimple (48), is smaller than a surface roughness (Rₐ₂) of a surface of the electrically conductive layer structure (20) in the opposed contact area (A2) with the larger extension (L2).

6. The component carrier (200, 300) according to any one of the preceding claims, wherein the stack (101) comprises at least one further cavity (41) being located at least partially within said at least one electrically insulating layer structure (30) and being arranged in stacking direction in between said two electrically conductive layer structures (10, 20),
wherein said further cavity (41) is in lateral direction (X) at least partially delimited by a lateral wall (45) of the electrically insulating layer structure (30),
said lateral wall (45) also having at least two opposed portions (43, 44) with different inclinations (α1, α2) relative to a contacting plane (11, 21) between the electrically insulating layer structure (30) and one of said two electrically conductive layer structures (10, 20) and with respect to a thickness direction (Z) of the stack (101).

7. The component carrier (200, 300) according to claim 6, wherein the inclination (α1, α2) of at least one lateral wall (45) or a portion (43, 44) thereof of the further cavity (41) relative to the contacting plane (11, 21) between the electrically insulating layer structure (30) and one of said two electrically conductive layer structures (10, 20) and with respect to the thickness direction (Z) of the stack (101) is different from the inclination (α1, α2) of at least one lateral wall (45) or a portion (43, 44) thereof of the first cavity (41) relative to the contacting plane between the electrically insulating layer structure (30) and one of said two electrically conductive layer structures (10, 20) and with respect to the thickness direction (Z) of the stack (101).

8. The component carrier (100, 200, 300, 400) according to any one of the preceding claims, wherein the component carrier (100, 200, 300, 400) comprises at least two sub-carriers (50', 60'), in particular at least a first sub-carrier (50') and a second sub-carrier (60'), each comprising at least one electrically conductive layer structure (10, 20),
wherein the at least two sub-carriers (50', 60') are stacked one above the other in thickness direction (Z) with at least one insulating layer structure (30) in between, and
wherein the respective electrically conductive layer structures (10, 20) of the respective sub-carriers (50', 60') stacked one above the other are electrically connected one to each other by at least one electrically conductive element (40),
wherein the electrically conductive element (40) comprises an electrically conductive paste (42) provided in a cavity (41) being located at least partially within the at least one electrically insulating layer structure (30) and in thickness direction (Z) in between said two electrically conductive layer structures (10, 20) being electrically connected one to each other,
wherein said cavity (41) is in lateral direction (X) at least partially delimited by a lateral wall (45) of the electrically insulating layer structure (30),
said lateral wall (45) having at least two opposed portions (43, 44) with different inclinations (α1, α2) relative to a contacting plane between the electrically insulating layer structure (30) and one of said two electrically conductive layer structures (10, 20) and with respect to a thickness direction (Z) of the stack (101).

9. The component carrier (100, 200, 300, 400) according to claim 8, wherein the component carrier (100, 200, 300, 400) further comprises at least one additional sub-carrier (50'), in particular a third sub-carrier (50'), wherein the component carrier (100, 200, 300, 400) preferably comprises two outer sub-carriers (50') and at least one inner sub-carrier (60'), the at least one inner sub-carrier (60') in particular being sandwiched in between the two outer sub-carriers (50').

10. The component carrier (100, 200, 300, 400) according to any one of the preceding claims, wherein at least one lateral wall (45) or a portion (43, 44) thereof of at least one cavity (41) tapers inwards to a center of the component carrier (100, 200, 300, 400).

11. The component carrier (100, 200, 300, 400) according to any one of the preceding claims, wherein the concentration of the conductive particles in the conductive paste (42) varies within the conductive paste (42) in the cavity (41).

12. The component carrier (100, 200, 300, 400) according to any one of the preceding claims, wherein the concentration of conductive particles within the conductive paste (42) in the cavity (41) is higher in a core area (46) of the at least one conductive element (40), in particular in a cube or square shaped core volume (46), in particular in a cube or square shaped core volume (46) extending between the two extremities of the at least one conductive element (40) in thickness direction (Z).

13. The component carrier (100, 200, 300, 400) according to any one of the preceding claims, wherein the concentration of conductive particles within the conductive paste (42) in the cavity (41) is higher on the frontal inclined lateral wall (47) of the cavity (41), in particular higher than on the rear inclined lateral wall (44).

14. The component carrier (100, 200, 300, 400) according to any one of the preceding claims, wherein said at least one electrically insulating layer structure (30), in which at least one cavity (41) is located at least partially, comprises a resin with a filling structure (31) within said resin,
wherein said cavity (41) exposes at least a portion of said filling structure (31) so that said portion contacts said conductive paste (42).

15. The component carrier (100, 200, 300, 400) according to claim 14, wherein the exposed portion of the filling structure (31) disrupts a profile of the lateral wall (45) of the insulating layer structure (30) delimiting the cavity (41) at least partially.

16. The component carrier (100, 200, 300, 400) according to claim 14 or 15, wherein the filling structure (31) comprises stiffening fibers (31), cloth and/or a fabric, in particular, wherein the profile of the lateral wall (45) is disrupted by exposed fibers (31) protruding inside the cavity (41), wherein in particular at least some of the exposed fibers (31) penetrate or protrude into the conductive paste (42) in the cavity (41).

17. The component carrier (100, 200, 300, 400) according to any one of the preceding claims, wherein the electrically conductive paste (42) comprises electrically conductive particles, wherein in particular a plurality of the electrically conductive particles are or comprise metal particles (42a), wherein the particles of the electrically conductive paste (42) are at least partially located between the exposed fibers (31), in particular the electrically conductive particles.

18. A method for manufacturing a component carrier (100, 200, 300, 400) according to any one of the claims 1 to 17, comprising at least the following steps:
- providing at least one insulating layer structure (30) and at least a first electrically conductive layer structure (10, 20), wherein the at least first electrically conductive layer structure (10, 20) is in particular arranged at one of the outer main surfaces of the insulating layer structure (30),
- creating a cavity (41) at least partially in the insulating layer structure (30), in particular from the outer surface of the insulating layer structure (30) facing away from the electrically conductive layer structure (10, 20) inwards and towards the electrically conductive layer structure (10, 20), preferably by using laser means,
- filling said cavity (41) at least partly with an electrically conductive paste (42),
- providing at least a second electrically conductive layer structure (20),
- forming a stack (101) such that the at least one electrically insulating layer structure (30) is stacked in between the first and second electrically conductive layer structures (10, 20), thereby arranging the cavity (41) with the electrically conductive paste (42) in it in thickness direction (Z) in between said two electrically conductive layer structures (10, 20), and electrically connecting the at least two electrically conductive layer structures (10, 20) one to each other by the electrically conductive paste (42) forming an electrically conductive element (40),
wherein the resulting cavity is in lateral direction (X) at least partially delimited by a lateral wall (45) of the electrically insulating layer structure (30),
said lateral wall (45) having at least two opposed portions (43, 44) with different inclinations (α1, α2) relative to a contacting plane between the electrically insulating layer structure (30) and one of said two electrically conductive layer structures (10, 20) and with respect to a thickness direction (Z) of the stack (101).

19. A component carrier assembly comprising a component carrier (100, 200, 300, 400) according to any one of the claims 1 to 17 and/or manufactured according to a method according to claim 18, and at least one further part.
